# EUROPEAN PATENT APPLICATION

(11) **EP 4 429 441 A2**
(43) Date of publication of application: **11.09.2024**
(21) Application number: 24155404.7
(22) Date of filing: 01.02.2024
(51) Int. Cl.: H10K 59/122, H10K 59/80

(54) **DISPLAY PANEL AND MANUFACTURING METHOD OF THE SAME**

(30) Priority: 15.02.2023 KR 20230020046
(71) Applicant: Samsung Display Co., Ltd., Gyeonggi-Do (KR)
(72) Inventor: PARK, Joonyong, Yongin-si (KR); SHIN, Hyuneok, Yongin-si (KR)
(74) Representative: Marks & Clerk LLP

(57) **Abstract**

A display panel (DP) includes a first anode (AE), a pixel defining layer (PDL) disposed on a base layer (BL) and provided with a first light emitting opening (OP-E), a partition wall (PW) disposed on the pixel defining layer (PDL) and provided with a first partition wall opening (OP-P) corresponding to the first light emitting opening (OP-E), a first conductive pattern (CPP) disposed in the first light emitting opening (OP-E) and disposed on the first anode (AE), a first cathode (CE) at least partially disposed in the first partition wall opening (OP-P) and disposed over the first conductive pattern (CPP), and a first emission pattern (EP) disposed between the first conductive pattern (CPP) and the first cathode (CE). The first conductive pattern (CPP) contacts a side surface (S-L) of the pixel defining layer (PDL) which defines the first light emitting opening (OP-E).

## Description

### BACKGROUND

### 1. Field

Embodiments of the disclosure described herein relate to a display panel and a manufacturing method thereof, and more particularly, relate to a display panel having improved process reliability and a manufacturing method thereof.

### 2. Description of the Related Art

A display device is typically activated based on an electrical signal. The display device may include a display panel that displays an image. Recently, an organic light emitting display panel having low power consumption, high luminance, and high response speed is widely used as the display panel in various fields.

The organic light emitting display panel typically includes anodes, cathodes, and emission patterns. The emission patterns may be separated for respective emissive regions, and the cathodes may provide a common voltage for the emissive regions.

### SUMMARY

Embodiments of the disclosure provide a display panel for improving process reliability and easily implementing high resolution by providing a light emitting element subjected to patterning without a metal mask.

Embodiments of the disclosure provide a display panel for preventing poor light emission and poor visibility by preventing formation of a void between an anode and an emission pattern.

Embodiments of the disclosure provide a display panel for improving display efficiency and electrical reliability while preventing poor light emission and poor visibility.

Embodiments of the disclosure provide a method of manufacturing a display panel including a light emitting element having improved process reliability without the use of a metal mask.

Embodiments of the disclosure provide a display panel manufacturing method for improving display efficiency and electrical reliability while preventing poor light emission and poor visibility.

According to an embodiment, a display panel includes a base layer, a first anode disposed on the base layer, a pixel defining layer disposed on the base layer, where the pixel defining layer is provided with a first light emitting opening which exposes at least a portion of the first anode, a partition wall disposed on the pixel defining layer, where the partition wall is provided with a first partition wall opening corresponding to the first light emitting opening, a first conductive pattern disposed in the first light emitting opening and disposed on the first anode, a first cathode at least partially disposed in the first partition wall opening and disposed over the first conductive pattern, and a first emission pattern disposed between the first conductive pattern and the first cathode. In such an embodiment, the first conductive pattern contacts a side surface of the pixel defining layer which defines the first light emitting opening.

In an embodiment, the pixel defining layer may include a lower insulating layer including a first insulating material, and an upper insulating layer including a second insulating material different from the first insulating material, where the upper insulating layer may be disposed on the lower insulating layer.

In an embodiment, the lower insulating layer may include a lower inner surface that defines a first lower region of the first light emitting opening. In such an embodiment, the upper insulating layer may include an upper inner surface which defines a first upper region of the first light emitting opening. In such an embodiment, the lower inner surface may be disposed to be recessed in a direction away from a center of the first anode with respect to the upper inner surface.

In an embodiment, the lower insulating layer may contact an upper surface of the first anode, and the first conductive pattern may contact the lower inner surface.

In an embodiment, the partition wall may include a first partition wall layer disposed on the upper insulating layer, where the first partition wall may include a first partition wall inner surface which defines a second lower region of the first partition wall opening, and a second partition wall layer disposed on the first partition wall layer, where the second partition wall may include a second partition wall inner surface which defines a second upper region of the first partition wall opening. In such an embodiment, the first partition wall inner surface may be disposed to be recessed in the direction away from the center of the first anode with respect to the upper inner surface and the second partition wall inner surface.

In an embodiment, the display panel may further include a first first dummy pattern spaced apart from the first conductive pattern and disposed in the first light emitting opening and the first partition wall opening, where the first first dummy pattern may include a same material as the first conductive pattern.

In an embodiment, the first first dummy pattern may contact the upper inner surface and the first partition wall inner surface, and a first dummy opening, which is disposed in the first light emitting opening and the first partition wall opening, may be defined in the first first dummy pattern.

In an embodiment, the first first dummy pattern may further contact a lower surface of the upper insulating layer exposed by the lower insulating layer.

In an embodiment, the display panel may further include a first second dummy pattern spaced apart from the first conductive pattern and the first first dummy pattern, where the first second dummy pattern may include a same material as the first conductive pattern. In such an embodiment, a portion of the first second dummy pattern may be disposed on the partition wall, and a remaining portion of the first second dummy pattern may be disposed in the first partition wall opening. The first second dummy pattern may contact the second partition wall inner surface, and a second dummy opening, which is disposed in the first partition wall opening, may be defined in the first second dummy pattern.

In an embodiment, the first second dummy pattern may further contact a lower surface of the second partition wall layer exposed by the first partition wall layer.

In an embodiment, the display panel may further include a third dummy pattern including a first dummy layer and a second dummy layer. In such an embodiment, the first dummy layer may be spaced apart from the first emission pattern and disposed on the first second dummy pattern and may include a same material as the first emission pattern, and the second dummy layer may be spaced apart from the first cathode and disposed on the first dummy layer and may include a same material as the first cathode. In such an embodiment, a third dummy opening corresponding to the first light emitting opening may be defined in the third dummy pattern.

In an embodiment, the display panel may further include a second anode disposed on the base layer and spaced apart from the first anode, a second conductive pattern disposed on the second anode, a second emission pattern disposed on the second conductive pattern, and a second cathode disposed on the second emission pattern. In such an embodiment, a second light emitting opening may be defined in the pixel defining layer to expose at least a portion of the second anode. In such an embodiment, a second partition wall opening corresponding to the second light emitting opening may be defined in the partition wall. In such an embodiment, the second conductive pattern, the second emission pattern, and the second cathode may be disposed in the second light emitting opening and the second partition wall opening.

In an embodiment, the display panel may further include a second first dummy pattern spaced apart from the second conductive pattern and disposed in the second light emitting opening and the second partition wall opening, where the second first dummy pattern may include a same material as the second conductive pattern, and a second second dummy pattern spaced apart from the second conductive pattern, the second first dummy pattern, and the first second dummy pattern, where the second second dummy pattern may include a same material as the second conductive pattern. In such an embodiment, a portion of the second second dummy pattern may be disposed on the partition wall, and a remaining portion of the second second dummy pattern may be disposed in the second partition wall opening.

In an embodiment, the first cathode may contact the first first dummy pattern in the first partition wall opening.

In an embodiment, the first cathode may contact the first partition wall inner surface in the first partition wall opening.

In an embodiment, the pixel defining layer may further include a first additional insulating layer disposed between the base layer and the lower insulating layer, where the first additional insulating layer may include a first additional inner surface which defines a first additional region of the first light emitting opening, and a second additional insulating layer disposed between the first additional insulating layer and the lower insulating layer, where the second additional insulating layer may include a second additional inner surface which defines a second additional region of the first light emitting opening. In such an embodiment, the first additional inner surface may be disposed to be recessed in the direction away from the center of the first anode with respect to the upper inner surface and the second additional inner surface. In such an embodiment, a portion of an upper surface of the first anode may contact the first additional insulating layer, and the first conductive pattern may contact the first additional inner surface.

In an embodiment, the first additional insulating layer may include the first insulating material, and the second additional insulating layer may include the second insulating material.

In an embodiment, the display panel may further include an additional dummy pattern spaced apart from the first conductive pattern and in contact with the second additional insulating layer and the lower insulating layer, where the additional dummy pattern may include a same material as the first conductive pattern.

In an embodiment, the first insulating material may include silicon nitride (SiNₓ), and the second insulating material may include silicon oxide (SiOₓ).

In an embodiment, each of the lower insulating layer and the upper insulating layer may have a thickness in a range of about 1000 angstroms (Å) to about 2000 Å.

In an embodiment, the first conductive pattern may include a same material as a material included in the first anode.

In an embodiment, the first conductive pattern may include transparent conductive oxide.

In an embodiment, the first conductive pattern may have a thickness in a range of about 30 Å to about 70 Å.

According to an embodiment, a display panel includes a base layer, an anode disposed on the base layer, a lower insulating layer disposed on the base layer and provided with a lower opening defined therein to expose a portion of the anode, an upper insulating layer disposed on the lower insulating layer and provided with an upper opening defined therein to correspond to the lower opening, a partition wall disposed on the upper insulating layer and provided with a partition wall opening defined therein to correspond to the upper opening, a conductive pattern disposed in the lower opening and disposed on the anode, a cathode at least partially disposed in the partition wall opening and disposed over the conductive pattern, and an emission pattern disposed between the conductive pattern and the cathode. In such an embodiment, on a section, the upper opening has a smaller width in one direction than the lower opening.

In an embodiment, the partition wall may include a first partition wall layer disposed on the upper insulating layer, where the first partition wall layer may include a first partition wall inner surface which defines one region of the partition wall opening, and a second partition wall layer disposed on the first partition wall layer, where the second partition wall layer may include a second partition wall inner surface which defines a remaining region of the partition wall opening. In such an embodiment, on the section, the remaining region of the partition wall opening may have a smaller width in the one direction than the one region of the partition wall opening.

According to an embodiment, a method for manufacturing a display panel includes providing a preliminary display panel including a base layer and a first anode disposed on the base layer, forming, on the base layer, a preliminary pixel defining layer including a lower insulating layer including a first insulating material and an upper insulating layer including a second insulating material different from the first insulating layer, forming a preliminary partition wall on the preliminary pixel defining layer, patterning the preliminary partition wall to form a partition wall with a first partition wall opening defined therein, patterning the preliminary pixel defining layer to form a pixel defining layer with a first light emitting opening defined therein to expose at least a portion of the first anode, forming a first conductive pattern to cover the first anode exposed by the first light emitting opening, forming a first emission pattern on the first conductive pattern, and forming a first cathode on the first emission pattern, where the first cathode is at least partially disposed in the first partition wall opening.

In an embodiment, the patterning the preliminary partition wall may include performing a first etching process by etching a first partition wall layer and a second partition wall layer of the preliminary partition wall to form a first preliminary partition wall opening in the preliminary partition wall and performing a second etching process by etching the first partition wall layer and the second partition wall layer to form the first partition wall opening from the first preliminary partition wall opening. In the performing the second etching process, an etch rate of the first partition wall layer may be higher than an etch rate of the second partition wall layer.

In an embodiment, the patterning the preliminary pixel defining layer may include performing a third etching processes, and in the performing the third etching process, an etch rate of the lower insulating layer may be higher than an etch rate of the upper insulating layer.

In an embodiment, the third etching process may be performed through a dry etching.

In an embodiment, in the forming the first conductive pattern, a first dummy pattern and a second preliminary dummy pattern may be additionally formed. In such an embodiment, the first dummy pattern may be spaced apart from the first conductive pattern and may be disposed in the first light emitting opening and the first partition wall opening, and the second preliminary dummy pattern may be spaced apart from the first conductive pattern and the first dummy pattern and may include one portion disposed on the partition wall and a remaining portion disposed in the first partition wall opening.

In an embodiment, the method may further include patterning the second preliminary dummy pattern to form a second dummy pattern after the forming the first conductive pattern and before the forming the first emission pattern. In such an embodiment, in the providing the preliminary display panel, the preliminary display panel may further include a second anode spaced apart from the first anode and disposed on the base layer. In such an embodiment, the patterning the second preliminary dummy pattern may include removing a portion of the second preliminary dummy pattern overlapping the second anode.

In an embodiment, the method may further include forming, in the partition wall, a second partition wall opening that overlaps the second anode after the forming the first cathode, forming, in the pixel defining layer, a second light emitting opening that exposes at least a portion of the second anode, forming a second conductive pattern to cover the second anode exposed by the second light emitting opening, forming a second emission pattern on the second conductive pattern, and forming, on the second emission pattern, a second cathode at least partially disposed in the second partition wall opening.

At least some of the above and other features of the invention are set out in the claims.

### BRIEF DESCRIPTION OF THE DRAWINGS

The above and other features of the disclosure will become apparent by describing in detail embodiments thereof with reference to the accompanying drawings.
FIG. 1A is a perspective view of a display device according to an embodiment of the disclosure.
FIG. 1B is an exploded perspective view of the display device according to an embodiment of the disclosure.
FIG. 2 is a sectional view of a display module according to an embodiment of the disclosure.
FIG. 3 is a plan view of the display panel according to an embodiment of the disclosure.
FIG. 4 is an enlarged plan view of a portion of a display region of the display panel according to an embodiment of the disclosure.
FIG. 5 is an enlarged sectional view of a partial region of the display panel according to an embodiment of the disclosure.
FIG. 6 is a sectional view of the display panel taken along line I-I' of FIG. 4 according to an embodiment of the disclosure.
FIG. 7 is an enlarged sectional view of a partial region of a display panel according to an embodiment of the disclosure.
FIGS. 8A and 8B are sectional views illustrating some of the steps of a display panel manufacturing method according to an embodiment of the disclosure.
FIGS. 9A to 9I are sectional views illustrating other steps of the display panel manufacturing method according to an embodiment of the disclosure.
FIGS. 10A to 10G are sectional views illustrating other steps of the display panel manufacturing method according to an embodiment of the disclosure.
FIGS. 11A to 11G are sectional views illustrating other steps of the display panel manufacturing method according to an embodiment of the disclosure.
FIG. 12 is a sectional view illustrating the other steps of the display panel manufacturing method according to an embodiment of the disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

In this specification, when it is mentioned that a component (or, a region, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

Terms such as first, second, and the like may be used to describe various components, but the components should not be limited by the terms. The terms may be used only for distinguishing one component from other components. For example, without departing the scope of the disclosure, a first component may be referred to as a second component, and similarly, the second component may also be referred to as the first component.

In addition, terms such as "below", "under", "above", and "over" are used to describe a relationship of components illustrated in the drawings. The terms are relative concepts and are described based on directions illustrated in the drawing.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms used herein, including technical or scientific terms, have the same meanings as those generally understood by those skilled in the art to which the disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the application.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the claims.

Hereinafter, embodiments of the disclosure will be described in detail with reference to the accompanying drawings.

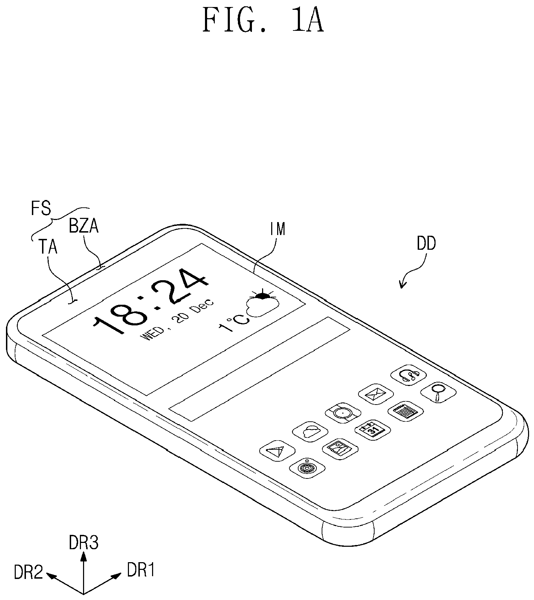

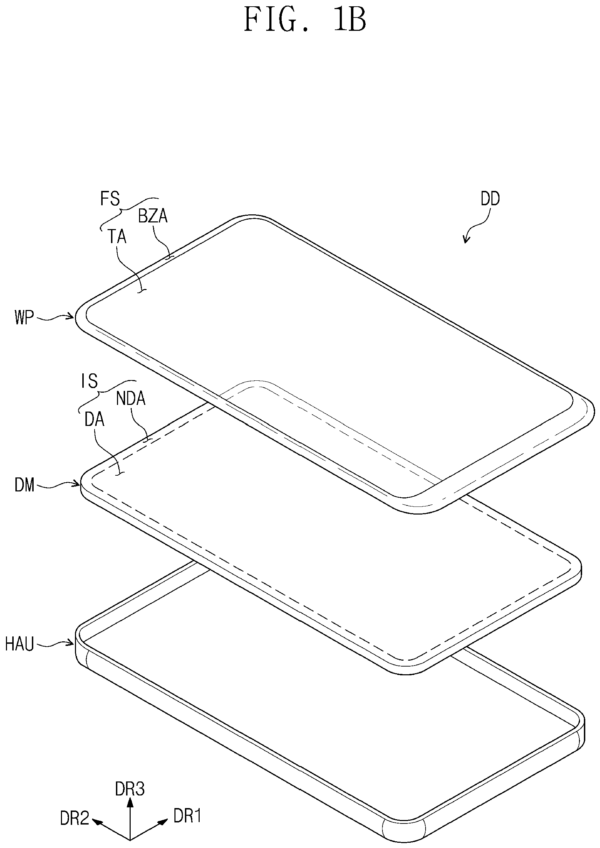

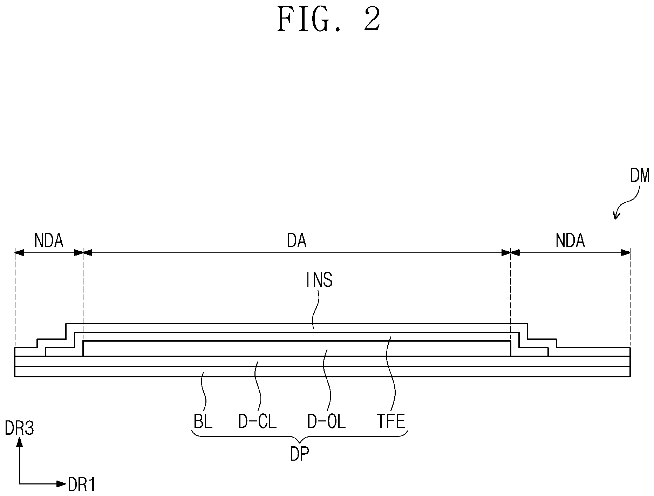

FIG. 1A is a perspective view of a display device according to an embodiment of the disclosure. FIG. 1B is an exploded perspective view of the display device according to an embodiment of the disclosure. FIG. 2 is a sectional view of a display module according to an embodiment of the disclosure.

In an embodiment, the display device DD may be a large electronic device such as a television, a monitor, or a billboard. In an embodiment, the display device DD may be a small and medium-sized electronic device such as a personal computer, a notebook computer, a personal digital terminal, a car navigation unit, a game machine, a smart phone, a tablet computer, or a camera. However, these devices are merely illustrative, and the display device DD may be employed as other display devices without departing from the scope of the disclosure. In an embodiment, as shown in FIGS. 1A and 1B, the display device DD may be a smart phone, for example.

Referring to FIGS. 1A, 1B, and 2, an embodiment of the display device DD may display an image IM in a third direction DR3 on a display surface FS that is parallel to a first direction DR1 and a second direction DR2. The image IM may include not only a dynamic image but also a still image. In an embodiment, as shown in FIG. 1A, the image IM may include a clock window and icons, for example. The display surface FS on which the image IM is displayed may correspond to a front surface of the display device DD.

In an embodiment, front surfaces (or, upper surfaces) and rear surfaces (or, lower surfaces) of members are defined based on the direction in which the image IM is displayed. The front surfaces and the rear surfaces may face away from each other in the third direction DR3, and normal directions of the front surfaces and the rear surfaces may be parallel to the third direction DR3. In the disclosure, the directions indicated by the first, second, and third directions DR1, DR2, and DR3 may be relative concepts and may be changed to different directions. As used herein, the expression "from above a plane" may mean when viewed in the third direction DR3.

As illustrated in FIG. 1B, the display device DD according to an embodiment may include a window WP, a display module DM, and a housing HAU. The window WP and the housing HAU may be coupled with each other to form an exterior of the display device DD.

The window WP may include an optically clear insulating material. In an embodiment, for example, the window WP may include glass or plastic. A front surface of the window WP may define the display surface FS of the display device DD. The display surface FS may include a transmissive region TA and a bezel region BZA. The transmissive region TA may be an optically clear region. In an embodiment, for example, the transmissive region TA may be a region having a visible light transmittance of about 90% or greater.

The bezel region BZA may be a region having a lower light transmittance than the transmissive region TA. The bezel region BZA may define the shape of the transmissive region TA. In an embodiment, the bezel region BZA may be adjacent to the transmissive region TA and may surround the transmissive region TA. However, this is illustrative, and in the window WP according to an alternative embodiment of the disclosure, the bezel region BZA may be omitted. The window WP may include at least one selected from an anti-fingerprint layer, a hard coating layer, and an anti-reflection layer, but is not limited to any one embodiment.

The display module DM may be disposed under the window WP. The display module DM may be a component that substantially generates the image IM. The image IM generated by the display module DM may be displayed on a display surface IS of the display module DM and may be visually recognized by a user from the outside through the transmissive region TA.

The display module DM includes a display region DA and a non-display region NDA. The display region DA may be a region activated based on an electrical signal. The non-display region NDA is adjacent to the display region DA. The non-display region NDA may surround the display region DA. The non-display region NDA may be a region covered by the bezel region BZA and may not be visible from the outside.

As illustrated in FIG. 2, the display module DM according to an embodiment may include the display panel DP and an input sensor INS. Although not separately illustrated, the display device DD according to an embodiment of the disclosure may further include a protective member disposed on a lower surface of the display panel DP and an anti-reflection member and/or a window member disposed on an upper surface of the input sensor INS.

The display panel DP may be an emissive display panel, but is not particularly limited. In an embodiment, for example, the display panel DP may be an organic light emitting display panel or an inorganic light emitting display panel. An emissive layer in the organic light emitting display panel includes an organic light emitting material. An emissive layer in the inorganic light emitting display panel includes a quantum dot, a quantum rod, or a micro light emitting diode (LED). Hereinafter, for convenience of description, embodiments where the display panel DP is an organic light emitting display panel will be described in detail.

The display panel DP may include a base layer BL, and a circuit element layer D-CL, a display element layer D-OL, and an encapsulation layer TFE that are disposed on the base layer BL. The input sensor INS may be directly disposed on the encapsulation layer TFE. As used herein, the expression "component A is directly disposed on component B" means that an adhesive layer is not disposed between component A and component B.

The base layer BL may include at least one plastic film. The base layer BL may be a flexible substrate and may include a plastic substrate, a glass substrate, a metal substrate, or an organic/inorganic composite substrate. In this specification, the display region DA and the non-display region NDA may be defined in the base layer BL, and components disposed on the base layer BL may overlap the display region DA or the non-display region NDA.

The circuit element layer D-CL includes at least one insulating layer and a circuit element. The insulating layer includes at least one inorganic layer and at least one organic layer. The circuit element includes signal lines and a pixel drive circuit.

The display element layer D-OL includes a partition wall and light emitting elements. Each of the light emitting elements may include an anode, an emission pattern, and a cathode, and the emission pattern may include an emissive layer.

The encapsulation layer TFE includes a plurality of thin films. Some of the thin films may be disposed to improve optical efficiency, and another of the thin films may be disposed to protect organic light emitting elements.

The input sensor INS obtains coordinate information of an external input. The input sensor INS may have a multi-layer structure. The input sensor INS may include a single conductive layer or multiple conductive layers. The input sensor INS may include a single insulating layer or multiple insulating layers. In an embodiment, for example, the input sensor INS may sense an external input in a capacitive manner. In the disclosure, an operating method of the input sensor INS is not particularly limited, and in an embodiment of the disclosure, the input sensor INS may sense an external input using an electromagnetic induction method or a pressure sensing method. In an alternative embodiment of the disclosure, the input sensor INS may be omitted.

In an embodiment, as illustrated in FIG. 1B, the housing HAU may be coupled with the window WP. The housing HAU may be coupled with the window WP to provide a predetermined inner space. The display module DM may be accommodated in the inner space.

The housing HAU may include a material having a relatively high rigidity. In an embodiment, for example, the housing HAU may include glass, plastic, or metal, or may include a plurality of frames and/or plates including or formed of a combination of the aforementioned materials. The housing HAU may stably protect components of the display device DD accommodated in the inner space from an external impact.

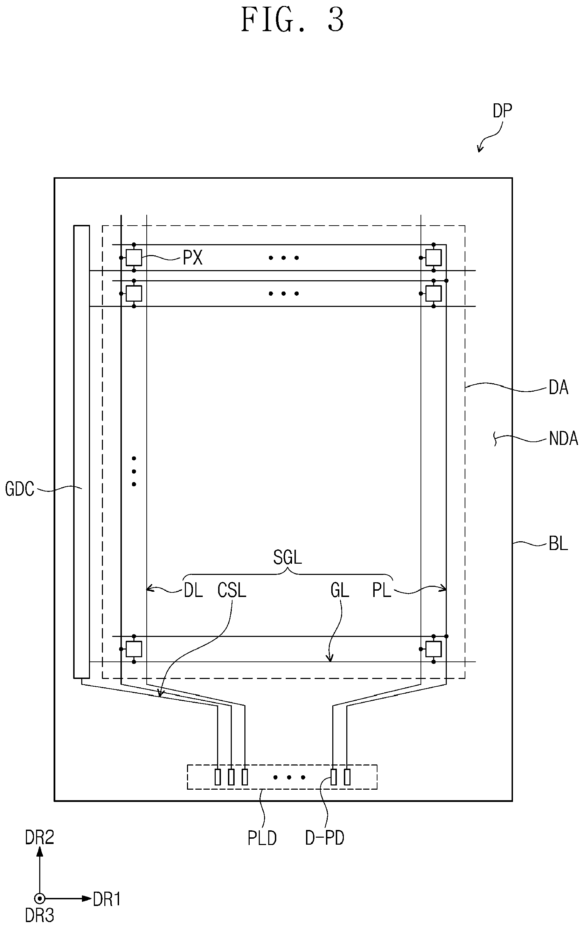

FIG. 3 is a plan view of the display panel according to an embodiment of the disclosure.

Referring to FIG. 3, an embodiment of the display panel DP may include the base layer BL divided into the display region DA and the non-display region NDA as described with reference to FIG. 2.

The display panel DP may include pixels PX disposed in the display region DA and signal lines SGL electrically connected to the pixels PX. The display panel DP may include a drive circuit GDC and a pad part PLD that are disposed in the non-display region NDA.

The pixels PX may be arranged in the first direction DR1 and the second direction DR2. The pixels PX may include a plurality of pixel rows that extend in the first direction DR1 and that are arranged in the second direction DR2 and a plurality of pixel columns that extend in the second direction DR2 and that are arranged in the first direction DR1.

The signal lines SGL may include gate lines GL, data lines DL, a power line PL, and a control signal line CSL. Each of the gate lines GL may be connected to a corresponding one of the pixels PX, and each of the data lines DL may be connected to a corresponding one of the pixels PX. The power line PL may be electrically connected to the pixels PX. The control signal line CSL may be connected to the drive circuit GDC and may provide control signals to the drive circuit GDC.

The drive circuit GDC may include a gate drive circuit. The gate drive circuit may generate gate signals and may sequentially output the generated gate signals to the gate lines GL. The gate drive circuit may additionally output other control signals to the pixel drive circuit.

The pad part PLD may be a part to which a flexible circuit board is connected. The pad part PLD may include pixel pads D-PD, and the pixel pads D-PD may be pads for connecting the flexible circuit board to the display panel DP. Each of the pixel pads D-PD may be connected with a corresponding one of the signal lines SGL. The pixel pads D-PD may be connected to the corresponding pixels PX through the signal lines SGL. Furthermore, one pixel pad among the pixel pads D-PD may be connected to the drive circuit.

In addition, the pad part PLD may further include input pads. The input pads may be pads for connecting a flexible circuit board to the input sensor INS (refer to FIG. 2). In an embodiment, without being limited thereto, the input pads may be disposed on the input sensor INS (refer to FIG. 2) and may be connected with the pixel pads D-PD and a separate circuit board. Alternatively, the input sensor INS (refer to FIG. 2) may be omitted and may not further include the input pads.

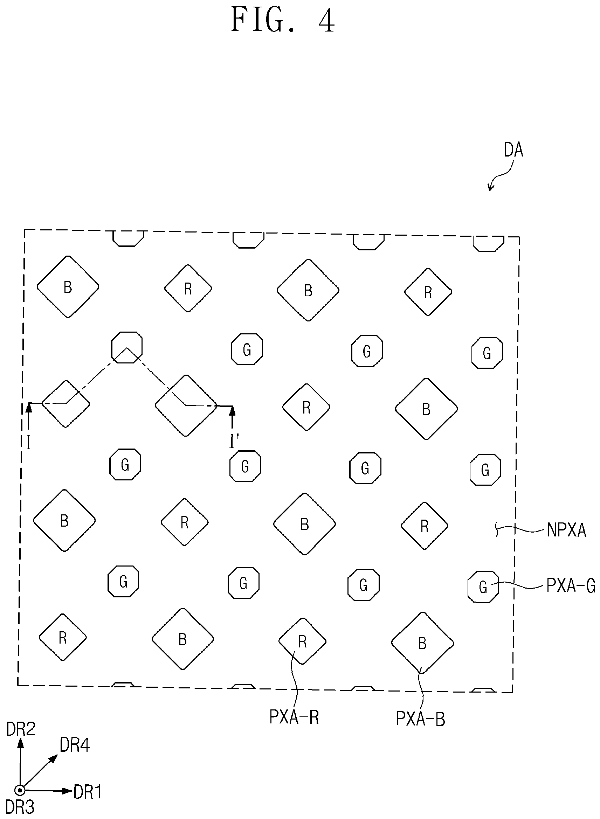

FIG. 4 is an enlarged plan view of a portion of the display region of the display panel according to an embodiment of the disclosure. FIG. 4 is a plan view of the display module DM (refer to FIG. 2) as viewed from above the display surface IS (refer to FIG. 2) of the display module DM (refer to FIG. 2) and illustrates an arrangement of emissive regions PXA-R, PXA-G, and PXA-B.

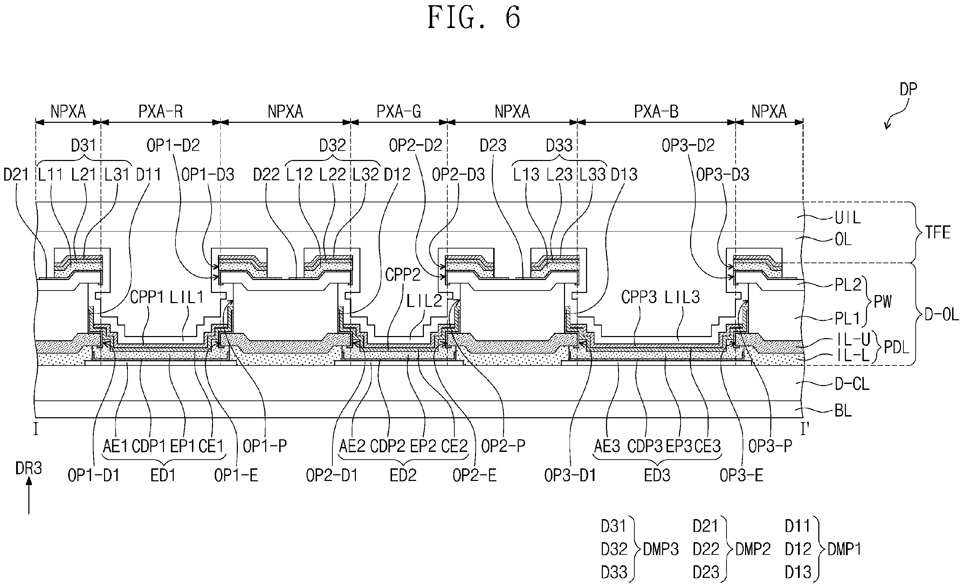

Referring to FIG. 4, an embodiment of the display region DA may include the first to third emissive regions PXA-R, PXA-G, and PXA-B and a peripheral region NPXA surrounding the first to third emissive regions PXA-R, PXA-G, and PXA-B. The first to third emissive regions PXA-R, PXA-G, and PXA-B may correspond to regions through which light provided from light emitting elements ED1, ED2, and ED3 (refer to FIG. 6) is emitted. The first to third emissive regions PXA-R, PXA-G, and PXA-B may be distinguished from one another depending on the colors of light beams emitted toward the outside of the display module DM (refer to FIG. 2).

The first to third emissive regions PXA-R, PXA-G, and PXA-B may provide first to third color lights having different colors from each other. In an embodiment, for example, the first color light may be red light, the second color light may be green light, and the third color light may be blue light. However, embodiments of the first to third color lights are not necessarily limited thereto.

Each of the first to third emissive regions PXA-R, PXA-G, and PXA-B may be defined as a region where an upper surface of an anode is exposed by a light emitting opening to be described below. The peripheral region NPXA may set or define the boundaries between the first to third emissive regions PXA-R, PXA-G, and PXA-B and may prevent color mixing between the first to third emissive regions PXA-R, PXA-G, and PXA-B.

Each of the first to third emissive regions PXA-R, PXA-G, and PXA-B may be provided in plural and may be repeatedly disposed in a predetermined arrangement form in the display region DA. In an embodiment, for example, the first and third emissive regions PXA-R and PXA-B may be alternately arranged in the first direction DR1 to form a "first group". The second emissive regions PXA-G may be arranged in the first direction DR1 to form a "second group". The "first group" and the "second group" may be provided in plural, and the "first groups" and the "second groups" may be alternately arranged in the second direction DR2.

One second emissive region PXA-G may be spaced apart from one first emissive region PXA-R or one third emissive region PXA-B in a fourth direction DR4. The fourth direction DR4 may be defined as a direction between the first and second directions DR1 and DR2.

Although FIG. 4 illustrates an embodiment of an arrangement form of the first, second, and third emissive regions PXA-R, PXA-G, and PXA-B, and without being limited thereto, the first, second, and third emissive regions PXA-R, PXA-G, and PXA-B may be arranged in various forms. In an embodiment, the first, second, and third emissive regions PXA-R, PXA-G, and PXA-B may have a PENTILE^{™} arrangement form as illustrated in FIG. 4. Alternatively, the first, second, and third emissive regions PXA-R, PXA-G, and PXA-B may have a stripe arrangement form or a Diamond Pixel^{™} arrangement form.

The first, second, and third emissive regions PXA-R, PXA-G, and PXA-B may have various shapes on the plane. In an embodiment, for example, the first, second, and third emissive regions PXA-R, PXA-G, and PXA-B may have a polygonal shape, a circular shape, or an oval shape. FIG. 4 illustrates an embodiment of the first and third emissive regions PXA-R and PXA-B having a quadrangular shape (or, a rhombic shape) on the plane and the second emissive regions PXA-G having an octagonal shape on the plane.

The first, second, and third emissive regions PXA-R, PXA-G, and PXA-B may have a same shape as each other on the plane, or at least some of the first, second, and third emissive regions PXA-R, PXA-G, and PXA-B may have different shapes from each other on the plane. FIG. 4 illustrates an embodiment where the first and third emissive regions PXA-R and PXA-B have the same shape as each other on the plane and the second emissive regions PXA-G has a shape different from that of the first and third emissive regions PXA-R and PXA-B.

At least some of the first, second, and third emissive regions PXA-R, PXA-G, and PXA-B may have different areas or sizes from each other on the plane. In an embodiment, the area of the first emissive region PXA-R that emits red light may be greater than the area of the second emissive region PXA-G that emits green light and may be smaller than the area of the third emissive region PXA-B that emits blue light. However, a relative size relationship between the first, second, and third emissive regions PXA-R, PXA-G, and PXA-B depending on emission colors is not limited thereto and may vary depending on the design of the display module DM (refer to FIG. 2). Alternatively, without being limited thereto, the first, second, and third emissive regions PXA-R, PXA-G, and PXA-B may have the same area as each other on the plane.

In such embodiments, the shapes, areas, and arrangement of the first, second, and third emissive regions PXA-R, PXA-G, and PXA-B of the display module DM (refer to FIG. 2) may be designed in various ways (or various modified) depending on the colors of emitted lights or the size and configuration of the display module DM (refer to FIG.2) and are not limited to the embodiment illustrated in FIG. 4.

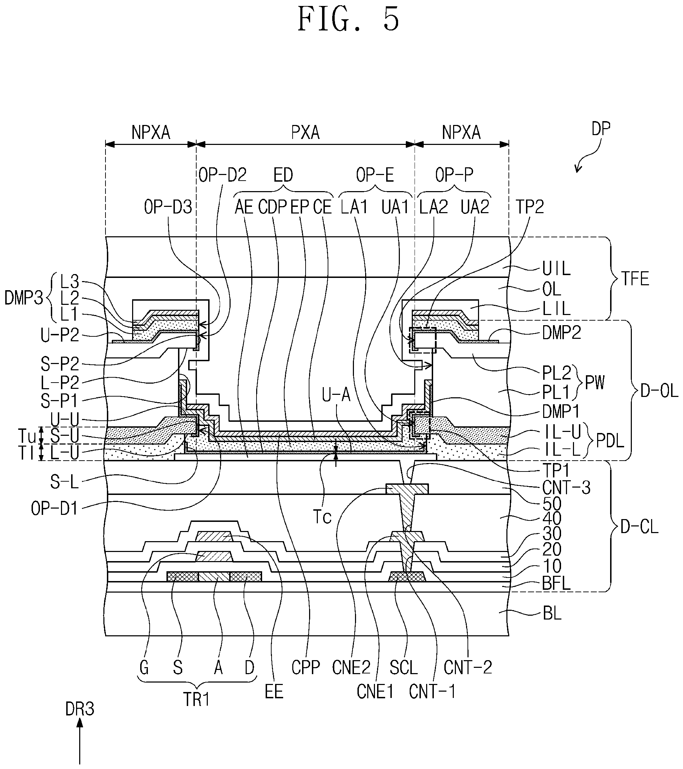

FIG. 5 is an enlarged sectional view of a partial region of the display panel according to an embodiment of the disclosure. FIG. 6 is a sectional view of the display panel taken along line I-I' of FIG. 4 according to an embodiment of the disclosure.

FIG. 5 is an enlarged view of one emissive region PXA in the display region DA (refer to FIG. 3), and the emissive region PXA of FIG. 5 may correspond to one of the first, second, and third emissive regions PXA-R, PXA-G, and PXA-B of FIG. 4. Referring to FIG. 5, an embodiment of the display panel DP may include the base layer BL, the circuit element layer D-CL, the display element layer D-OL, and the encapsulation layer TFE.

The display panel DP may include a plurality of insulating layers, a semiconductor pattern, a conductive pattern, and a signal line. An insulating layer, a semiconductor layer, and a conductive layer are formed by coating, deposition, or the like. Thereafter, the insulating layer, the semiconductor layer, and the conductive layer may be selectively subjected to patterning by photolithography and etching. The semiconductor pattern, the conductive pattern, and the signal line included in the circuit element layer D-CL and the display element layer D-OL may be formed by the above-described method.

The circuit element layer D-CL may be disposed on the base layer BL. The circuit element layer D-CL may include a buffer layer BFL, a transistor TR1, a signal transmission region SCL, first to fifth insulating layers 10, 20, 30, 40, and 50, an electrode EE, and a plurality of connecting electrodes CNE1 and CNE2.

The buffer layer BFL may be disposed on the base layer BL. The buffer layer BFL may improve a bonding force between the base layer BL and a semiconductor pattern. The buffer layer BFL may include at least one selected from silicon oxide layers and silicon nitride layers. In an embodiment, the buffer layer BFL may include the silicon oxide layers and the silicon nitride layers which are alternately stacked one above another.

The semiconductor pattern may be disposed on the buffer layer BFL. The semiconductor pattern may include poly-silicon. Alternatively, without being limited thereto, the semiconductor pattern may include amorphous silicon or metal oxide. FIG. 5 illustrates only a portion of the semiconductor pattern, and the semiconductor pattern may be additionally disposed in the plurality of emissive regions PXA-R, PXA-G, and PXA-B (refer to FIG. 4). The semiconductor pattern may be arranged across the plurality of emissive regions PXA-R, PXA-G, and PXA-B (refer to FIG. 4) according to a specific rule. The semiconductor pattern may have different electrical properties depending on whether the semiconductor pattern is doped or not. The semiconductor pattern may include a first region having a high doping concentration and a second region having a low doping concentration. The first region may be doped with an N-type dopant or a P-type dopant. A P-type transistor may include a first region doped with a P-type dopant.

The first region may have a higher conductivity than the second region and may substantially serve as an electrode or a signal line. The second region may substantially correspond to an active (or, channel) region of the transistor. In other words, one portion of the semiconductor pattern may be the active region of the transistor, another portion of the semiconductor pattern may be a source or drain of the transistor, and another portion of the semiconductor pattern may be a conductive region.

A source S, an active region A, and a drain D of the transistor TR1 may be formed from (or defined by portions of) the semiconductor pattern. FIG. 5 illustrates a portion of the signal transmission region SCL formed from the semiconductor pattern. Although not separately illustrated, the signal transmission region SCL may be connected to the drain D of the transistor TR1 on the plane.

The first to fifth insulating layers 10, 20, 30, 40, and 50 may be disposed on the buffer layer BFL. The first to fifth insulating layers 10 to 50 may be inorganic layers or organic layers.

The first insulating layer 10 may be disposed on the buffer layer BF. A gate G may be disposed on the first insulating layer 10. The second insulating layer 20 may be disposed on the first insulating layer 10 and may cover the gate G. The electrode EE may be disposed on the second insulating layer 20. The third insulating layer 30 may be disposed on the second insulating layer 20 and may cover the electrode EE.

The first connecting electrode CNE1 may be disposed on the third insulating layer 30. The first connecting electrode CNE1 may be connected to the signal transmission region SCL through a contact hole CNT-1 defined through the first, second, and third insulating layers 10, 20, and 30. The fourth insulating layer 40 may be disposed on the third insulating layer 30 and may cover the first connecting electrode CNE1. The fourth insulating layer 40 may be an organic layer.

The second connecting electrode CNE2 may be disposed on the fourth insulating layer 40. The second connecting electrode CNE2 may be connected to the first connecting electrode CNE1 through a contact hole CNT-2 defined through the fourth insulating layer 40. The fifth insulating layer 50 may be disposed on the fourth insulating layer 40 and may cover the second connecting electrode CNE2. The fifth insulating layer 50 may be an organic layer.

The display element layer D-OL may be disposed on the circuit element layer D-CL. The display element layer D-OL may include a light emitting element ED, a pixel defining layer PDL, a partition wall PW, a first dummy pattern DMP1, a second dummy pattern DMP2, and a third dummy pattern DMP3.

In the disclosure, the light emitting element ED may include an anode AE (or, a first electrode), a conductive pattern CDP, an emission pattern EP, and a cathode CE (or, a second electrode). The above-described first to third light emitting elements may include substantially the same configuration as the light emitting element ED of FIG. 5. Features of the anode AE, the conductive pattern CDP, the emission pattern EP, and the cathode CE described above may be identically applied to anodes, conductive patterns, emission patterns, and cathodes of the first to third light emitting elements.

The anode AE may be disposed on the fifth insulating layer 50 of the circuit element layer D-CL. The anode AE may be a transparent electrode, a translucent electrode, or a reflective electrode. The anode AE may have conductivity. In an embodiment, for example, as long as the anode AE is capable of having conductivity, the anode AE may include or be formed of at least one selected from various materials such as metal, transparent conductive oxide (TCO), or a conductive polymer material. The anode AE may be formed of (or defined by) a single layer, or may be formed of multiple layers. In an embodiment, the anode AE may be formed of three layers that include indium tin oxide (ITO), silver (Ag), and indium tin oxide (ITO), respectively.

The anode AE may be connected to the second connecting electrode CNE2 by a connection contact hole CNT-3 defined through the fifth insulating layer 50. Accordingly, the anode AE may be electrically connected to the signal transmission region SCL through the first and second connecting electrodes CNE1 and CNE2 and may be electrically connected to a corresponding circuit element.

The pixel defining layer PDL may be disposed on the fifth insulating layer 50 of the circuit element layer D-CL. The pixel defining layer PDL may be provided with a light emitting opening OP-E, that is, the light emitting opening OP-E may be defined through the pixel defining layer PDL. The light emitting opening OP-E may overlap the anode AE, and the pixel defining layer PDL may expose at least a portion of the anode AE through the light emitting opening OP-E. The pixel defining layer PDL may be disposed between the anode AE and the partition wall PW and may block electrical connection between the anode AE and the partition wall PW.

In an embodiment, the pixel defining layer PDL may include a lower insulating layer IL-L and an upper insulating layer IL-U disposed on the lower insulating layer IL-L. A portion of an upper surface U-A of the anode AE may contact the lower insulating layer IL-L.

The lower insulating layer IL-L may include a first insulating material, and the upper insulating layer IL-U may include a second insulating material different from the first insulating material. Both the first insulating material and the second insulating material may be inorganic insulating materials. In an embodiment, the first insulating material may include silicon nitride (SiNₓ), and the second insulating material may include silicon oxide (SiOₓ). Alternatively, without being limited thereto, the first insulating material and the second insulating material may be selected as a combination of materials having etch selectivity in a patterning process of the pixel defining layer PDL that will be described below. In such an embodiment, the etch rate of the first insulating material may be higher than the etch rate of the second insulating material. Detailed description thereof will be given below.

In an embodiment, the lower insulating layer IL-L may be relatively recessed with respect to the emissive region PXA when compared to the upper insulating layer IL-U. That is, the lower insulating layer IL-L may be undercut with respect to the upper insulating layer IL-U. A portion of the upper insulating layer IL-U that protrudes from the lower insulating layer IL-L toward the emissive region PXA may define a first tip portion TP1.

In an embodiment, the light emitting opening OP-E may include a first lower region LA1 and a first upper region UA1. The lower insulating layer IL-L may include a lower inner surface S-L that defines the first lower region LA1 of the light emitting opening OP-E. The upper insulating layer IL-U may include an upper inner surface S-U that defines the first upper region UA1 of the light emitting opening OP-E.

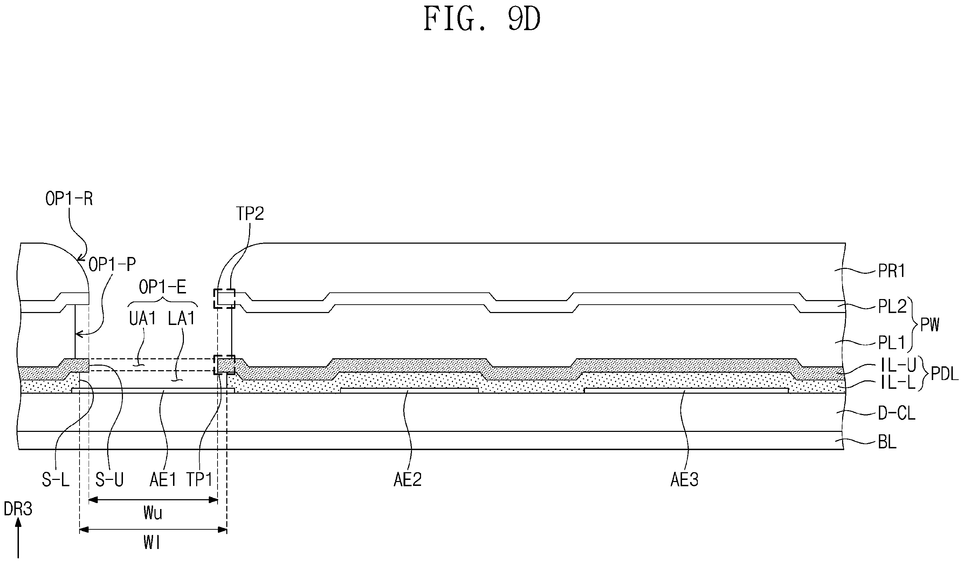

On the section, the width Wu (refer to FIG. 9D) of the first upper region UA1 in one direction may be smaller than the width Wl (refer to FIG. 9D) of the first lower region LA1 in the one direction. The upper inner surface S_U may be closer to a center of the anode AE than the lower inner surface S-L. In other words, the lower inner surface S-L may be disposed to be recessed in a direction away from the center of the anode AE when compared to (or with respect to) the upper inner surface S-U.

According to an embodiment of the disclosure, the pixel defining layer PDL constituted by the plurality of insulating layers may prevent the conductive pattern CDP on the anode AE from being electrically connected with the partition wall PW, and thus the display panel DP having improved electrical reliability may be provided. Detailed description thereof will be given below.

The emissive region PXA may be defined as a region of the anode AE exposed by the first upper region UA1 of the light emitting opening OP-E.

In the disclosure, the first lower region LA1 of the light emitting opening OP-E may be referred to as a "lower opening", and the first upper region UA1 of the light emitting opening OP-E may be referred to as an "upper opening".

In an embodiment, the lower insulating layer IL-L may have a thickness Tl in a range of about 1000 angstrom (Å) to about 2000 Å, and the upper insulating layer IL-U may have a thickness Tu in a range of about 1000 Å to about 2000 Å.

In a case in which the thickness Tl of the lower insulating layer IL-L is less than about 1000 Å, the space between the anode AE and the upper insulating layer IL-U that is provided from the undercut shape of the pixel defining layer PDL may be narrowed, and therefore a void may not be effectively prevented from being formed between the anode AE and the emission pattern EP. In a case in which the thickness Tu of the upper insulating layer IL-U is less than about 1000 Å, the first tip portion TP1 of the pixel defining layer PDL may be thin, and therefore the portion of the upper insulating layer IL-U that defines the first tip portion TP1 may be bent. In a case in which the thickness Tl of the lower insulating layer IL-L and/or the thickness Tu of the upper insulating layer IL-U exceed about 2000 Å, the pixel defining layer PDL may be thickened, and therefore the cathode CE may not be connected to the partition wall PW and may be partially separated.

FIG. 5 illustrates an embodiment where the lower inner surface S-L and the upper inner surface S-U are perpendicular to an upper surface of the fifth insulating layer 50. alternatively, without being limited thereto, the lower insulating layer IL-L and the upper insulating layer IL-U may have a tapered shape, or may have an inverted tapered shape.

The partition wall PW may be disposed on the pixel defining layer PDL. The partition wall PW may be provided with a partition wall opening OP-P. The partition wall opening OP-P may correspond to the light emitting opening OP-E and may expose at least a portion of the anode AE. In this disclosure, the expression "one region/portion corresponds to another region /portion" used herein means that the regions/portions overlap each other and is not limited to having a same area as each other. Accordingly, the expression "one opening corresponds to another opening" used herein means that the two openings overlap each other and is not limited to having a same area as each other.

The partition wall PW may have an undercut shape on the section. The partition wall PW may include multiple layers sequentially stacked one above another, and at least one layer among the multiple layers may be recessed when compared to layers stacked adjacent thereto. Accordingly, the partition wall PW may include a second tip portion TP2.

In an embodiment, the partition wall PW may include a first partition wall layer PL1 and a second partition wall layer PL2. The first partition wall layer PL1 may be disposed on the pixel defining layer PDL, and the second partition wall layer PL2 may be disposed on the first partition wall layer PL1. The first partition wall layer PL1 may have first conductivity, and the second partition wall layer PL2 may have second conductivity lower than the first conductivity. The first partition wall layer PL1 may be thicker than the second partition wall layer PL2.

In an embodiment, the first partition wall layer PL1 may be relatively recessed with respect to the emissive region PXA when compared to the second partition wall layer PL2. That is, the first partition wall layer PL1 may be undercut with respect to the second partition wall layer PL2. A portion of the second partition wall layer PL2 that protrudes further than the first partition wall layer PL1 toward a center of the emissive region PXA may define the second tip portion TP2.

In an embodiment, the partition wall opening OP-P may include a second lower region LA2 and a second upper region UA2. The first partition wall layer PL1 may include a first partition wall inner surface S-P1 that defines the second lower region LA2 of the partition wall opening OP-P. The second partition wall layer PL2 may include a second partition wall inner surface S-P2 that defines the second upper region UA2 of the partition wall opening OP-P.

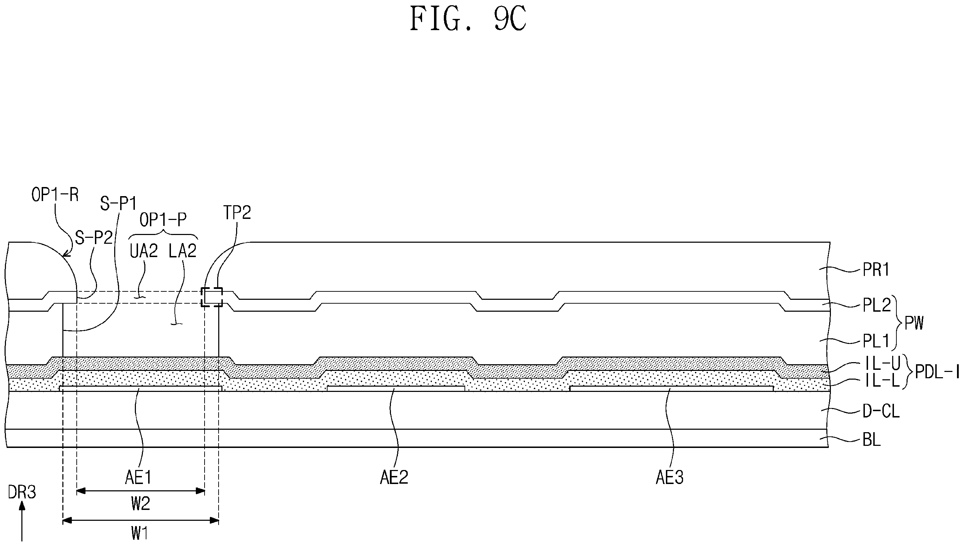

On the section, the width W2 (refer to FIG. 9C) of the second upper region UA2 in the one direction may be smaller than the width W1 (refer to FIG. 9C) of the second lower region LA2 in the one direction. The second partition wall inner surface S-P2 may be closer to the center of the anode AE than the first partition wall inner surface S-P1. In other words, the first partition wall inner surface S-P1 may be disposed to be recessed in a direction away from the center of the anode AE when compared to the second partition wall inner surface S-P2.

In an embodiment, the first partition wall layer PL1 may include a conductive material. The conductive material may include metal, transparent conductive oxide (TCO), or a combination thereof. In an embodiment, for example, the metal may include gold (Au), silver (Ag), aluminum (Al), magnesium (Mg), lithium (Li), molybdenum (Mo), titanium (Ti), copper (Cu), or an alloy thereof. The transparent conductive oxide may include indium tin oxide (ITO), indium zinc oxide (IZO), zinc oxide, indium oxide, indium gallium oxide, indium gallium zinc oxide (IGZO), or aluminum zinc oxide.

In an embodiment, the second partition wall layer PL2 may include metal, metal oxide, metal nitride, or non-metal. In an embodiment, for example, the metal may include gold (Au), silver (Ag), aluminum (Al), magnesium (Mg), lithium (Li), molybdenum (Mo), titanium (Ti), copper (Cu), or an alloy thereof. The metal oxide may include transparent conductive oxide (TCO). The non-metal may include silicon (Si), silicon oxide (SiOₓ), silicon nitride (SiNₓ), silicon oxy-nitride (SiON), or a combination thereof.

FIG. 5 illustrates an embodiment where the first and second partition wall inner surfaces S-P1 and S-P2 are perpendicular to the upper surface of the fifth insulating layer 50. Alternatively, without being limited thereto, the first partition wall layer PL1 and the second partition wall layer PL2 may have a tapered shape, or may have an inverted tapered shape.

The conductive pattern CDP may be disposed in the first lower region LA1 of the light emitting opening OP-E. The conductive pattern CDP may make contact with and directly cover the portion of the anode AE exposed by (or through) the first lower region LA1. The conductive pattern CDP may make contact with a side surface of the pixel defining layer PDL that defines the light emitting opening OP-E. In such an embodiment, the conductive pattern CDP may make contact with a portion of the lower inner surface S-L of the lower insulating layer IL-L.

The conductive pattern CDP may include a conductive material. In an embodiment, the conductive pattern CDP may include transparent conductive oxide (TCO). In an embodiment, for example, the conductive pattern CDP may include at least one selected from indium tin oxide (ITO), indium zinc oxide (IZO), and indium gallium zinc oxide (IGZO). In an embodiment in which the conductive pattern CDP includes indium tin oxide (ITO), the content of indium oxide (InOₓ) may be higher than the content of tin oxide (SnOₓ). In an embodiment, for example, the conductive pattern CDP may include indium tin oxide (ITO) composed of 90 weight percent (wt%) of indium oxide (InOₓ) and 10 wt% of tin oxide (SnOₓ).

In an embodiment, the conductive pattern CDP may include a same material as a material included in the anode AE. In an embodiment in which the anode AE is provided in a single layer structure, the conductive pattern CDP may include a same material as the material of the single layer, and in an embodiment in which the anode AE is provided in a multi-layer structure, the conductive pattern CDP may include a same material as a material of the uppermost layer of the anode AE. In an embodiment, for example, in an embodiment in which the anode AE is formed of three layers that include indium tin oxide (ITO), silver (Ag), and indium tin oxide (ITO), respectively, the conductive pattern CDP may include indium tin oxide (ITO).

In a case in which an etch stopper is disposed between the anode AE and the pixel defining layer PDL to prevent damage to the anode AE in a patterning process of the pixel defining layer PDL, the etch stopper may be recessed with respect to the emissive region PXA when compared to the pixel defining layer PDL, and a narrow space may be formed between the anode AE and the pixel defining layer PDL. In this case, a void (or an empty space) extending from the narrow space may be formed in a process of forming the emission pattern EP, and therefore the display panel DP having poor light emission and poor visibility may be provided.

According to embodiments of the disclosure, the separate etch stopper may not be disposed between the anode AE and the pixel defining layer PDL, and thus the narrow space by the recessed etch stopper may not be formed. Accordingly, the void may be effectively prevented from being formed between the anode AE and the emission pattern EP, and the display panel DP capable of preventing the poor light emission and the poor visibility may be provided. In such embodiments, even though the pixel defining layer PDL includes the lower insulating layer IL-L relatively recessed when compared to the upper insulating layer IL-U and therefore has an undercut shape, a void may not be formed in the space resulting from the undercut shape in the pixel defining layer PDL since the lower insulating layer IL-L has a thickness greater than or equal to a predetermined thickness.

Furthermore, according to embodiments of the disclosure, even though the separate etch stopper is not disposed and therefore the anode AE is damaged during the patterning process of the pixel defining layer PDL, the conductive pattern CDP covering the anode AE may effectively prevent the function of the anode AE from being deteriorated. In an embodiment, even though an interface of the anode AE is damaged during the patterning process of the pixel defining layer PDL and a work function is decreased, an interface substantially making contact with the emission pattern EP may be provided by the undamaged conductive pattern CDP, and thus a hole injection function may be effectively prevented from being deteriorated. Accordingly, in such an embodiment, an increase in the drive voltage of the light emitting element ED may be effectively prevented, and the display panel DP having improved display efficiency may be provided.

In an embodiment, the conductive pattern CDP may have a thickness Tc in a range of about 30 Å to about 70 Å. In a case in which the thickness Tc of the conductive pattern CDP is less than about 30 Å, a hole injection function may not be recovered, and in a case in which the thickness Tc of the conductive pattern CDP exceeds about 70 Å, the conductive pattern CDP may not be electrically isolated near the first tip portion TP1 defined in the pixel defining layer PDL and may be electrically connected with the partition wall PW.

The emission pattern EP may be disposed on the conductive pattern CDP. The emission pattern EP may be subjected to patterning by the first tip portion TP1 defined in the pixel defining layer PDL and the second tip portion TP2 defined in the partition wall PW. At least a portion of the emission pattern EP may be disposed in the light emitting opening OP-E. FIG. 5 illustrates an embodiment where the emission pattern EP is disposed in the light emitting opening OP-E. However, the disclosure is not limited thereto, and in an alternative embodiment, the emission pattern EP may be disposed in the partition wall opening OP-P. In such an embodiment, a portion of the emission pattern EP may be disposed on an upper surface U-U of the upper insulating layer IL-U exposed by the first partition wall layer PL1.

The emission pattern EP may include an emissive layer including a luminescent material. The emission pattern EP may further include a hole injection layer (HIL) and a hole transport layer (HTL) that are disposed between the anode AE and the emissive layer and may further include an electron transport layer (ETL) and an electron injection layer (EIL) that are disposed on the emissive layer. The emission pattern EP may be referred to as an "organic layer" or an "intermediate layer".

The cathode CE may be disposed on the emission pattern EP. The cathode CE may be subjected to patterning by the first tip portion TP1 defined in the pixel defining layer PDL and the second tip portion TP2 defined in the partition wall PW. At least a portion of the cathode CE may be disposed in the partition wall opening OP-P. FIG. 5 illustrates an embodiment where the cathode CE is disposed in the light emitting opening OP-E and the partition wall opening OP-P. Alternatively, without being limited thereto, the cathode CE may be disposed only in the partition wall opening OP-P depending on the thickness of the emission pattern EP or the thickness of the pixel defining layer PDL.

The cathode CE may have conductivity. In an embodiment, for example, as long as the cathode CE is capable of having conductivity, the cathode CE may include or be formed of at least one selected from various materials such as metal, transparent conductive oxide (TCO), or a conductive polymer material. The cathode CE may be electrically connected with the first partition wall layer PL1. A structure in which the cathode CE is connected to the first partition wall layer PL1 will be described below.

In an embodiment, the partition wall PW may receive a bias voltage. The cathode CE may be electrically connected to the partition wall PW and may receive the bias voltage from the partition wall PW.

According to an embodiment of the disclosure, the display panel DP may further include a capping pattern CPP. The capping pattern CPP may be disposed on the cathode CE. The capping pattern CPP may be subjected to patterning by the second tip portion TP2 defined in the partition wall PW. A t least a portion of the capping pattern CPP may be disposed in the partition wall opening OP-P. FIG. 5 illustrates an embodiment where the capping pattern CPP is disposed in the partition wall opening OP-P and the light emitting opening OP-E. Alternatively, without being limited thereto, the capping pattern CPP may be disposed only in the partition wall opening OP-P depending on the thickness of the emission pattern EP or the thickness of the pixel defining layer PDL.

The first dummy pattern DMP1 may be disposed in the light emitting opening OP-E and the partition wall opening OP-P. The first dummy pattern DMP1 may make contact with the upper inner surface S-U of the upper insulating layer IL-U and the first partition wall inner surface S-P1 of the first partition wall layer PL1 and may cover the upper inner surface S-U and a portion of the first partition wall inner surface S-P1. The first dummy pattern DMP1 may make contact with the upper surface U-U of the upper insulating layer IL-U exposed by the first partition wall layer PL1 and may cover the upper surface U-U of the upper insulating layer IL-U. In an embodiment, the first dummy pattern DMP1 may be disposed to additionally make contact with a portion of a lower surface L-U of the upper insulating layer IL-U exposed by the lower insulating layer IL-L.

The first dummy pattern DMP1 may extend along the upper inner surface S-U and the first partition wall inner surface S-P1 and may have a closed-line shape on the plane. A first dummy opening OP-D1 corresponding to the light emitting opening OP-E may be defined in the first dummy pattern DMP1. The first dummy opening OP-D1 may be defined in the light emitting opening OP-E and the partition wall opening OP-P.

A portion of the first dummy pattern DMP1 that makes contact with the first partition wall layer PL1 may be brought into contact with the cathode CE, and the cathode CE may be connected to the first partition wall layer PL1 through the first dummy pattern DMP1. Alternatively, the cathode CE may be brought into contact with a portion of the first partition wall inner surface S-P1 of the first partition wall layer PL1 that is exposed by the first dummy pattern DMP1 and may be connected to the first partition wall layer PL1. In an embodiment, as illustrated in FIG. 5, the cathode CE may include both a portion brought into contact with the first dummy pattern DMP1 and a portion brought into contact with the first partition wall inner surface S-P1. In an alternative embodiment, the cathode CE may be formed not to make contact with the first partition wall inner surface S-P1 but to make contact with the first dummy pattern DMP1. In such an embodiment, the cathode CE may be connected to the first partition wall layer PL1 through the first dummy pattern DMP1.

The second dummy pattern DMP2 may include one portion disposed on the partition wall PW and another portion disposed in the partition wall opening OP-P. The second dummy pattern DMP2 may make contact with an upper surface UP2 of the second partition wall layer PL2 adjacent to the partition wall opening OP-P and the second partition wall inner surface S-P2 of the second partition wall layer PL2. In an embodiment, the second dummy pattern DMP2 may be disposed to additionally make contact with a portion of a lower surface L-P2 of the second partition wall layer PL2 exposed by (or by not being covered by) the first partition wall layer PL1.

The second dummy pattern DMP2 may extend along the second partition wall inner surface S-P2 of the second partition wall layer PL2 and may have a closed-line shape on the plane. A second dummy opening OP-D2 corresponding to the light emitting opening OP-E may be defined in the second dummy pattern DMP2. The second dummy opening OP-D2 may be defined in the second upper region UA2 of the partition wall opening OP-P.

In an embodiment, the first dummy pattern DMP1 and the second dummy pattern DMP2 may include a conductive material. The first dummy pattern DMP1 and the second dummy pattern DMP2 may include a same material as the conductive pattern CDP. The first dummy pattern DMP1 and the second dummy pattern DMP2 may be simultaneously formed with the conductive pattern CDP through one process. The first dummy pattern DMP1 may be separated (or disconnected) from the conductive pattern CDP by the first tip portion TP1 defined in the pixel defining layer PDL, and the second dummy pattern DMP2 may be separated from the conductive pattern CDP and the first dummy pattern DMP1 by the second tip portion TP2 defined in the partition wall PW.

According to an embodiment of the disclosure, the pixel defining layer PDL may be provided in a multi-layer structure including the lower insulating layer IL-L and the upper insulating layer IL-U and may have an undercut shape. Accordingly, the pixel defining layer PDL may provide the first tip portion TP1 capable of separating the conductive pattern CDP and the first dummy pattern DMP1. Thus, electrical connection between the conductive pattern CDP and the partition wall PW and lateral leakage current between the anode AE and the partition wall PW may be prevented, and the display panel DP having improved electrical reliability may be provided.

The third dummy pattern DMP3 may be disposed on the second dummy pattern DMP2 on the partition wall PW. The third dummy pattern DMP3 may include a first dummy layer L1, a second dummy layer L2, and a third dummy layer L3. The first to third dummy layers L1, L2, and L3 may be sequentially stacked in the third direction DR3.

The first dummy layer L1 may include an organic material. In an embodiment, for example, the first dummy layer L1 may include the same material as the emission pattern EP. The first dummy layer L1 may be simultaneously formed with the emission pattern EP through one process (or a same process) and may be separated from the emission pattern EP by the undercut shape of the partition wall PW.

The second dummy layer L2 may include a conductive material. In an embodiment, for example, the second dummy layer L2 may include the same material as the cathode CE. The second dummy layer L2 may be simultaneously formed with the cathode CE through one process and may be separated from the cathode CE by the undercut shape of the partition wall PW.

The third dummy layer L3 may include the same material as the capping pattern CPP. The third dummy layer L3 may be simultaneously formed with the capping pattern CPP through one process and may be separated from the capping pattern CPP by the undercut shape of the partition wall PW.

A third dummy opening OP-D3 corresponding to the light emitting opening OP-E may be defined in the third dummy pattern DMP3. The third dummy opening OP-D3 may be defined by inner surfaces of the first to third dummy layers L1, L2, and L3. On the plane, the third dummy pattern DMP3 may have a closed-line shape extending along the outer boundary of the emissive region PXA.

FIG. 5 illustrates an embodiment where the inner surfaces of the first to third dummy layers L1, L2, and L3 that define the third dummy opening OP-D3 are aligned with the inner surface of the second dummy pattern DMP2 that defines the second dummy opening OP-D2. Alternatively, without being limited thereto, the first to third dummy layers L1, L2, and L3 may cover the second dummy pattern DMP2 in the second dummy opening OP-D2.

The encapsulation layer TFE may be disposed on the display element layer D-OL. The encapsulation layer TFE may include a lower inorganic encapsulation pattern LIL, an organic encapsulation layer OL, and an upper inorganic encapsulation layer UIL.

The lower inorganic encapsulation pattern LIL may cover the light emitting element ED. in an embodiment, the lower inorganic encapsulation pattern LIL may cover the cathode CE. In an embodiment, the lower inorganic encapsulation pattern LIL may also cover the capping pattern CPP disposed on the cathode CE.

A portion of the lower inorganic encapsulation pattern LIL may be disposed in the light emitting opening OP-E and the partition wall opening OP-P. In the partition wall opening OP-P, the lower inorganic encapsulation pattern LIL may be brought into contact with the first partition wall inner surface S-P1, the lower surface L-P2 of the second partition wall layer PL2 exposed by the first partition wall layer PL1, and the second dummy pattern DMP2 disposed in the partition wall opening OP-P. Another portion of the lower inorganic encapsulation pattern LIL may be disposed on the partition wall PW. The lower inorganic encapsulation pattern LIL may be brought into contact with the upper surface of the third dummy pattern DMP3 and the inner surfaces of the third dummy pattern DMP3 that define the third dummy opening OP-D3.

The organic encapsulation layer OL may cover the lower inorganic encapsulation pattern LIL and may provide a flat upper surface. The upper inorganic encapsulation layer UIL may be disposed on the organic encapsulation layer OL.

The lower inorganic encapsulation pattern LIL and the upper inorganic encapsulation layer UIL may protect the display element layer D-OL from moisture/oxygen, and the organic encapsulation layer OL may protect the display element layer D-OL from foreign matter such as dust particles.

FIG. 6 is an enlarged view illustrating one first emissive region PXA-R, one second emissive region PXA-G, and one third emissive region PXA-B, and the description of the emissive region PXA of FIG. 5 may be identically applied to the first to third emissive regions PXA-R, PXA-G, and PXA-B.

Referring to FIG. 6, the display panel DP according to an embodiment may include the base layer BL, the circuit element layer D-CL, the display element layer D-OL, and the encapsulation layer TFE. The display element layer D-OL may include the light emitting elements ED1, ED2, and ED3, the pixel defining layer PDL, the partition wall PW, the first dummy patterns DMP1, the second dummy patterns DMP2, and the third dummy patterns DMP3. Although the circuit element layer D-CL is schematically illustrated in FIG. 6, the description of the circuit element layer D-CL of FIG. 5 may be identically applied thereto.

The light emitting elements ED1, ED2, and ED3 may include the first light emitting element ED1, the second light emitting element ED2, and the third light emitting element ED3.

The first light emitting element ED1 may include a first anode AE1, a first conductive pattern CDP1, a first emission pattern EP1, and a first cathode CE1, the second light emitting element ED2 may include a second anode AE2, a second conductive pattern CDP2, a second emission pattern EP2, and a second cathode CE2, and the third light emitting element ED3 may include a third anode AE3, a third conductive pattern CDP3, a third emission pattern EP3, and a third cathode CE3. The first to third anodes AE1, AE2, and AE3 may be provided in (or defined by) a plurality of patterns. In an embodiment, the first emission pattern EP1 may provide red light, the second emission pattern EP2 may provide green light, and the third emission pattern EP3 may provide blue light.

The pixel defining layer PDL may include the lower insulating layer IL-L and the upper insulating layer IL-U. In an embodiment, the pixel defining layer PDL may be provided with first to third light emitting openings OP1-E, OP2-E, and OP3-E. The light emitting opening OP-E described above with reference to FIG. 5 may correspond to one of the first, second, and third light emitting openings OP1-E, OP2-E, and OP3-E, and the description of the light emitting opening OP-E given above with reference to FIG. 5 may be identically applied to the first, second, and third light emitting openings OP1-E, OP2-E, and OP3-E.

Each of the first to third light emitting openings OP1-E, OP2-E, and OP3-E may include the first lower region LA1 and the first upper region UA1 described above with reference to FIG. 5. The lower insulating layer IL-L may include the lower inner surfaces S-L (refer to FIG. 5) that define the first lower regions LA1 (refer to FIG. 5) of the first to third light emitting openings OP1-E, OP2-E, and OP3-E, respectively, and the upper insulating layer IL-U may include the upper inner surfaces S-U (refer to FIG. 5) that define the first upper regions UA1 (refer to FIG. 5) of the first to third light emitting openings OP1-E, OP2-E, and OP3-E, respectively.

The first light emitting opening OP1-E may expose at least a portion of the first anode AE1. The first emissive region PXA-R may be defined as a region of an upper surface of the first anode AE1 exposed by (or through) the first upper region UA1 (refer to FIG. 5) of the first light emitting opening OP1-E. The second light emitting opening OP2-E may expose at least a portion of the second anode AE2. The second emissive region PXA-G may be defined as a region of an upper surface of the second anode AE2 exposed by the first upper region UA1 (refer to FIG. 5) of the second light emitting opening OP2-E. The third light emitting opening OP3-E may expose at least a portion of the third anode AE3. The third emissive region PXA-B may be defined as a region of an upper surface of the third anode AE3 exposed by the first upper region UA1 (refer to FIG. 5) of the third light emitting opening OP3-E.

The partition wall PW may include the first partition wall layer PL1 and the second partition wall layer PL2. In an embodiment, the partition wall PW may include first, second, and third partition wall openings OP1-P, OP2-P, and OP3-P that correspond to the first, second, and third light emitting openings OP1-E, OP2-E, and OP3-E, respectively. The partition wall opening OP-P described above with reference to FIG. 5 may correspond to one of the first, second, and third partition wall openings OP1-P, OP2-P, and OP3-P, and the description of the partition wall opening OP-P given above with reference to FIG. 5 may be identically applied to the first, second, and third partition wall openings OP1-P, OP2-P, and OP3-P.

Each of the first to third partition wall openings OP1-P, OP2-P, and OP3-P may include the second lower region LA2 and the second upper region UA2 described above with reference to FIG. 5. The first partition wall layer PL1 may include the first partition wall inner surfaces S-P1 (refer to FIG. 5) that define the second lower regions LA2 (refer to FIG. 5) of the first to third partition wall openings OP1-P, OP2-P, and OP3-P, respectively, and the second partition wall layer PL2 may include the second partition wall inner surfaces S-P2 (refer to FIG. 5) that define the second upper regions UA2 (refer to FIG. 5) of the first to third partition wall openings OP1-P, OP2-P, and OP3-P, respectively.

The first conductive pattern CDP1, the first emission pattern EP1, and the first cathode CE1 may be disposed in the first light emitting opening OP1-E and the first partition wall opening OP1-P. The second conductive pattern CDP2, the second emission pattern EP2, and the second cathode CE2 may be disposed in the second light emitting opening OP2-E and the second partition wall opening OP2-P. The third conductive pattern CDP3, the third emission pattern EP3, and the third cathode CE3 may be disposed in the third light emitting opening OP3-E and the third partition wall opening OP3-P.

The first conductive pattern CDP1 may be disposed between the first anode AE1 and the first emission pattern EP1 and may cover a portion of the first anode AE1 exposed by the lower insulating layer IL-L. The second conductive pattern CDP2 may be disposed between the second anode AE2 and the second emission pattern EP2 and may cover a portion of the second anode AE2 exposed by the lower insulating layer IL-L. The third conductive pattern CDP3 may be disposed between the third anode AE3 and the third emission pattern EP3 and may cover a portion of the third anode AE3 exposed by the lower insulating layer IL-L.

According to an embodiment of the disclosure, even though the first to third anodes AE1, AE2, and AE3 are damaged in patterning processes of the pixel defining layer PDL that form the first to third light emitting openings OP1-E, OP2-E, and OP3-E, the first to third conductive patterns CDP1, CDP2, and CDP3 covering the first to third anodes AE1, AE2, and AE3, respectively, may effectively prevent deterioration in a hole injection function of the first to third light emitting elements ED1, ED2, and ED3.

The first to third cathodes CE1, CE2, and CE3 may be electrically connected with the first partition wall layer PL1. In an embodiment, the first to third cathodes CE1, CE2, and CE3 may be physically separated by the second tip portions TP2 (refer to FIG. 5) defined in the partition wall PW, but may be electrically connected to the first partition wall layer PL1 in the partition wall openings OP1-P, OP2-P, and OP3-P. Accordingly, all of the first to third cathodes CE1, CE2, and CE3 may receive a common voltage.

In an embodiment, the first partition wall layer PL1 may have a higher electrical conductivity and a greater thickness than the second partition wall layer PL2 and thus may decrease contact resistance with the first to third cathodes CE1, CE2, and CE2 and/or the first to third first dummy patterns D11, D12, and D13 to be described below. Accordingly, a common cathode voltage may be uniformly provided for the emissive regions PXA-R, PXA-G, and PXA-B.

According to an embodiment of the disclosure, the plurality of first emission patterns EP1 may be patterned and deposited in pixel units by the second tip portions TP2 (refer to FIG. 5) defined in the partition wall PW. That is, the first emission patterns EP1 may be commonly formed by using an open mask, but may be easily divided in pixel units by the partition wall PW.

In contrast, in a case in which the first emission patterns EP1 are patterned by using a fine metal mask (FMM), a spacer for support that protrudes from the partition wall is desired to be provided to support the fine metal mask. In this case, since the fine metal mask is spaced, by the height of the partition wall and the spacer, apart from a base surface on which patterning is performed, there may be a limitation in the implementation of high resolution. In addition, since the fine metal mask is brought into contact with the spacer, foreign matter may remain on the spacer after the patterning process of the first emission patterns EP1, or the spacer may be damaged by a dent defect of the fine metal mask. Therefore, a display panel may be formed with a defect. The description thereabout may be identically applied to a case of forming the second emission patterns EP2 subject to patterning and a case of forming the third emission patterns EP3 subject to patterning.

According to an embodiment of the disclosure, since the partition wall PW is included, the physical separation between the light emitting elements ED1, ED2, and ED3 may be easily performed. Accordingly, current leakage or a driving error between the adjacent emissive regions PXA-R, PXA-G, and PXA-B may be effectively prevented, and the light emitting elements ED1, ED2, and ED3 may be independently driven.

In such an embodiment, by making the plurality of first emission patterns EP1 subject to patterning without using a mask in contact with an internal component in the display region DA (refer to FIG. 2), a defect rate may be reduced, and thus the display panel DP having improved process reliability may be provided. The description thereof may be identically applied to a case of forming the second emission patterns EP2 subject to patterning and a case of forming the third emission patterns EP3 subject to patterning. Since patterning is possible even though the separate spacer for support that protrudes from the partition wall PW is not provided, the areas of the emissive regions PXA-R, PXA-G, and PXA-B may be effectively scaled down, and thus the display panel DP capable of easily implementing high resolution may be provided.

In such an embodiment, in the manufacture of a large-area display panel DP, the manufacture of a large-area mask may be omitted. Accordingly, process costs may be reduced, and the display panel DP may not be affected by defects that are likely to occur in the large-area mask. Thus, the display panel DP having improved process reliability may be provided.

In an embodiment, the display panel DP may further include a first capping pattern CPP1, a second capping pattern CPP2, and a third capping pattern CPP3. The first to third capping patterns CPP1, CPP2, and CPP3 may be disposed on the first to third cathodes CE1, CE2, and CE3, respectively, and may be disposed in the first to third light emitting openings OP1-E, OP2-E, and OP3-E and the first to third partition wall openings OP1-P, OP2-P, and OP3-P.

In an embodiment, the first dummy patterns DMP1 may include a first first dummy pattern (hereinafter, will be referred to as "dummy pattern 1-1") D11, a second first dummy pattern (hereinafter, will be referred to as "dummy pattern 1-2") D12, and a third first dummy pattern (hereinafter, will be referred to as "dummy pattern 1-3") D13. The description of the first dummy pattern DMP1 given above with reference to FIG. 5 may be identically applied to the dummy pattern 1-1 D11, the dummy pattern 1-2 D12, and the dummy pattern 1-3 D13.

The dummy pattern 1-1 D11 may be disposed in the first light emitting opening OP1-E and the first partition wall opening OP1-P, the dummy pattern 1-2 D12 may be disposed in the second light emitting opening OP2-E and the second partition wall opening OP2-P, and the dummy pattern 1-3 D13 may be disposed in the third light emitting opening OP3-E and the third partition wall opening OP3-P.

The dummy patterns 1-1 D11, 1-2 D12, and 1-3 D13 may define dummy openings 1-1 OP1-D1, 1-2 OP2-D1, and 1-3 OP3-D1 that are defined in the first to third light emitting openings OP1-E, OP2-E, and OP3-E and the first to third partition wall openings OP1-P, OP2-P, and OP3-P, respectively.

In an embodiment, the second dummy patterns DMP2 may include a first second dummy pattern (hereinafter, will be referred to as "dummy pattern 2-1") D21, a second second dummy pattern (hereinafter, will be referred to as "dummy pattern 2-2") D22, and a third second dummy pattern (hereinafter, will be referred to as "dummy pattern 2-3") D23. The description of the second dummy pattern DMP2 given above with reference to FIG. 5 may be identically applied to the dummy pattern 2-1 D21, the dummy pattern 2-2 D22, and the dummy pattern 2-3 D23.

One portion of the dummy pattern 2-1 D21 may be disposed in the first partition wall opening OP1-P, and another portion of the dummy pattern 2-1 D21 may be disposed on the upper surface U-P2 (refer to FIG. 5) of the second partition wall layer PL2 that is adjacent to the first partition wall opening OP1-P. One portion of the dummy pattern 2-2 D22 may be disposed in the second partition wall opening OP2-P, and another portion of the dummy pattern 2-2 D22 may be disposed on the upper surface U-P2 (refer to FIG. 5) of the second partition wall layer PL2 that is adjacent to the second partition wall opening OP2-P. One portion of the dummy pattern 2-3 D23 may be disposed in the third partition wall opening OP3-P, and another portion of the dummy pattern 2-3 D23 may be disposed on the upper surface U-P2 (refer to FIG. 5) of the second partition wall layer PL2 that is adj acent to the third partition wall opening OP3-P. The dummy pattern 2-1 D21, the dummy pattern 2-2 D22, and the dummy pattern 2-3 D23 may be spaced apart from each other on the upper surface U-P2 (refer to FIG. 5) of the second partition wall layer PL2.

The dummy patterns 2-1 D21, 2-2 D22, and 2-3 D23 may define dummy openings 2-1 OP1-D2, 2-2 OP2-D2, and 2-3 OP3-D2 defined in the first to third partition wall openings OP1-P, OP2-P, and OP3-P, respectively.

In this embodiment, the third dummy patterns DMP3 may include a first third dummy pattern (hereinafter, will be referred to as "dummy pattern 3-1") D31, a second third dummy pattern (hereinafter, will be referred to as "dummy pattern 3-2") D32, and a third third dummy pattern (hereinafter, will be referred to as "dummy pattern 3-3") D33. The dummy patterns 3-1 D31, 3-2 D32, and 3-3 D33 may be disposed on the dummy patterns 2-1 D21, 2-2 D22, and 2-3 D23, respectively.

The dummy pattern 3-1 D31 may include a dummy layer 1-1 L11, a dummy layer 2-1 L21, and a dummy layer 3-1 L31, the dummy pattern 3-2 D32 may include a dummy layer 1-2 L12, a dummy layer 2-2 L22, and a dummy layer 3-2 L32, and the dummy pattern 3-3 D33 may include a dummy layer 1-3 L13, a dummy layer 2-3 L23, and a dummy layer 3-3 L33. The description of the first dummy layer L1 given above with reference to FIG. 5 may be identically applied to the dummy layers 1-1 L11, 1-2 L12, and 1-3 L13 of FIG. 6, the description of the second dummy layer L2 given above with reference to FIG. 5 may be identically applied to the dummy layers 2-1 L21, 2-2 L22, and 2-3 L23 of FIG. 6, and the description of the third dummy layer L3 given above with reference to FIG. 5 may be identically applied to the dummy layers 3-1 L31, 3-2 L32, and 3-3 L33 of FIG. 6.

A dummy opening 3-1 OP1-D3, a dummy opening 3-2 OP2-D3, and a dummy opening 3-3 OP3-D3 corresponding to the first to third light emitting openings OP1-E, OP2-E, and OP3-E may be defined in the dummy patterns 3-1 D31, 3-2 D32, and 3-3 D33. The dummy opening 3-1 OP1-D3 may be defined by inner surfaces of the dummy layers 1-1 L11, 2-1 L21, and 3-1 L31 of the dummy pattern 3-1 D31. The dummy opening 3-2 OP2-D3 may be defined by inner surfaces of the dummy layers 1-2 L12, 2-2 L22, and 3-2 L32 of the dummy pattern 3-2 D32. The dummy opening 3-3 OP3-D3 may be defined by inner surfaces of the dummy layers 1-3 L13, 2-3 L23, and 3-3 L33 of the dummy pattern 3-3 D33.

The encapsulation layer TFE may include lower inorganic encapsulation patterns LIL1, LIL2, and LIL3, the organic encapsulation layer OL, and the upper inorganic encapsulation layer UIL.

In an embodiment, the lower inorganic encapsulation patterns LIL1, LIL2, and LIL3 may include the first lower inorganic encapsulation pattern LIL1, the second lower inorganic encapsulation pattern LIL2, and the third lower inorganic encapsulation pattern LIL3. The first to third lower inorganic encapsulation patterns LIL1, LIL2, and LIL3 may be provided in pattern forms spaced apart from each other.

The first to third lower inorganic encapsulation patterns LIL1, LIL2, and LIL3 may cover the first to third light emitting elements ED1, ED2, and ED3, respectively. in an embodiment, the first to third lower inorganic encapsulation patterns LIL1, LIL2, and LIL3 may cover the first to third cathodes CE1, CE2, and CE3, respectively. In an embodiment, the first to third lower inorganic encapsulation patterns LIL1, LIL2, and LIL3 may also cover the first to third capping patterns CPP1, CPP2, and CPP3 disposed on the first to third cathodes CE1, CE2, and CE3.

The first lower inorganic encapsulation pattern LIL1 may be provided in a pattern form that overlaps the first light emitting opening OP1-E and does not overlap the second and third light emitting openings OP2-E and OP3-E. One portion of the first lower inorganic encapsulation pattern LIL1 may be disposed in the first light emitting opening OP1-E and the first partition wall opening OP1-P, and another portion of the first lower inorganic encapsulation pattern LIL1 may be disposed on a portion of the partition wall PW that is adj acent to the first partition wall opening OP1-P and may cover the dummy pattern 3-1 D31.

The second lower inorganic encapsulation pattern LIL2 may be provided in a pattern form that overlaps the second light emitting opening OP2-E and does not overlap the first and third light emitting openings OP1-E and OP3-E. One portion of the second lower inorganic encapsulation pattern LIL2 may be disposed in the second light emitting opening OP2-E and the second partition wall opening OP2-P, and another portion of the second lower inorganic encapsulation pattern LIL2 may be disposed on a portion of the partition wall PW that is adj acent to the second partition wall opening OP2-P and may cover the dummy pattern 3-2 D32.

The third lower inorganic encapsulation pattern LIL3 may be provided in a pattern form that overlaps the third light emitting opening OP3-E and does not overlap the first and second light emitting openings OP1-E and OP2-E. One portion of the third lower inorganic encapsulation pattern LIL3 may be disposed in the third light emitting opening OP3-E and the third partition wall opening OP3-P, and another portion of the third lower inorganic encapsulation pattern LIL3 may be disposed on a portion of the partition wall PW that is adjacent to the third partition wall opening OP3-P and may cover the dummy pattern 3-3 D33.

According to an embodiment, the emission patterns EP1, EP2, and EP3 may be provided in pattern forms, and the lower inorganic encapsulation patterns LIL1, LIL2, and LIL3 may be provided in pattern forms that cover the light emitting elements ED1, ED2, and ED3, respectively. Accordingly, a moisture permeation path may be effectively prevented from being formed between the adjacent light emitting elements ED1, ED2, and ED3, and defects of the light emitting elements ED1, ED2, and ED3 due to moisture permeation may be reduced.

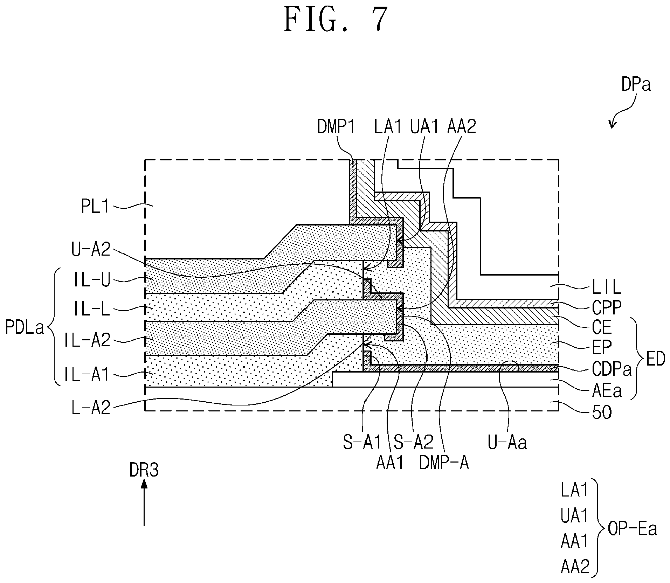

FIG. 7 is an enlarged sectional view of a partial region of a display panel according to an embodiment of the disclosure. FIG. 7 illustrates an enlarged view of a portion adjacent to a light emitting opening OP-Ea included in a pixel defining layer PDLa. Components identical or similar to the components described with reference to FIGS. 5 to 6 will be assigned with identical or similar reference numerals, and any repetitive detailed descriptions thereof will be omitted.

Referring to FIG. 7, the pixel defining layer PDLa according to an embodiment may include a first additional insulating layer II,-A1, a second additional insulating layer IL-A2, a lower insulating layer IL-L, and an upper insulating layer IL-U. In such an embodiment, the pixel defining layer PDLa may further include the first and second additional insulating layers IL-A1 and IL-A2 in addition to the lower insulating layer IL-L, and the upper insulating layer IL-U described above with reference to FIGS. 5 and 6 .

The first additional insulating layer IL-A1 may be disposed between the base layer BL (refer to FIG. 5) and the lower insulating layer IL-L. In an embodiment, the first additional insulating layer IL-A1 may be disposed on the fifth insulating layer 50 and may cover at least a portion of an anode AEa. According to an embodiment, a portion of an upper surface U-Aa of the anode AEa may be brought into contact with the first additional insulating layer IL-A1. The second additional insulating layer IL-A2 may be disposed between the first additional insulating layer IL-A1 and the lower insulating layer IL-L.

The first additional insulating layer IL-A1 may include a same material as the lower insulating layer IL-L, and the second additional insulating layer IL-A2 may include a same material as the upper insulating layer IL-U. That is, the first additional insulating layer IL-A1 may include a first insulating material, and the second additional insulating layer IL-A2 may include a second insulating material.

The light emitting opening OP-Ea may include a first additional region AA1, a second additional region AA2, a first lower region LA1, and a first upper region UA1. In such an embodiment, the light emitting opening OP-Ea may further include the first and second additional regions AA1 and AA2 in addition to the first lower region LA1, and the first upper region UA1 described above with reference to FIGS. 5 and 6.

The first additional insulating layer IL-A1 may include a first additional inner surface S-A1 that defines the first additional region AA1 of the light emitting opening OP-Ea, and the second additional insulating layer IL-A2 may include a second additional inner surface S-A2 that defines the second additional region AA2 of the light emitting opening OP-Ea.

The first additional insulating layer IL-A1 may be relatively recessed with respect to an emissive region PXA (refer to FIG. 5) when compared to the second additional insulating layer IL-A2. That is, the first additional insulating layer IL-A1 may be undercut with respect to the second additional insulating layer IL-A2. A portion of the second additional insulating layer IL-A2 that protrudes from the first additional insulating layer IL-A1 toward the center of the emissive region PXA (refer to FIG. 5) may define an additional tip portion.

The first additional inner surface S-A1 may be disposed to be recessed in a direction away from the center of the anode AEa when compared to the second additional inner surface S-A2. The second additional inner surface S-A2 may be closer to the center of the anode AEa than the first additional inner surface S-A1 and the lower inner surface S-L (refer to FIG. 5).

A light emitting element ED may include the anode AEa, a conductive pattern CDPa, an emission pattern EP, and a cathode CE. In an embodiment, the conductive pattern CDPa may be disposed in the first additional region AA1 and may make contact with the first additional insulating layer IL-A1. In an embodiment, the conductive pattern CDPa may make contact with the first additional inner surface S-A1.

In an embodiment, the display panel DPa may further include an additional dummy pattern DMP-A. The additional dummy pattern DMP-A may be disposed in the light emitting opening OP-Ea. The additional dummy pattern DMP-A may make contact with the second additional insulating layer IL-A2 and the lower insulating layer IL-L. In an embodiment, the additional dummy pattern DMP-A may make contact with the second additional inner surface S-A2 and the lower inner surface S-L (refer to FIG. 5). In addition, the additional dummy pattern DMP-A may make contact with a lower surface L-A2 of the second additional insulating layer IL-A2 exposed by the first additional insulating layer IL-A1 and an upper surface U-A2 of the second additional insulating layer IL-A2 exposed by the lower insulating layer ILL.

The additional dummy pattern DMP-A may include a same material as the conductive pattern CDPa. The additional dummy pattern DMP-A may be simultaneously formed with the conductive pattern CDPa through one process. The additional dummy pattern DMP-A may be separated from the conductive pattern CDPa by the additional tip portion defined in the pixel defining layer PDLa. Furthermore, in this embodiment, a first dummy pattern DMP1 may be separated from the conductive pattern CDPa and the additional dummy pattern DMP-A by the first tip portion TP1 (refer to FIG. 5) defined in the pixel defining layer PDLa. The conductive pattern CDPa, the additional dummy pattern DMP-A, and the first dummy pattern DMP1 may all be spaced apart from each other.

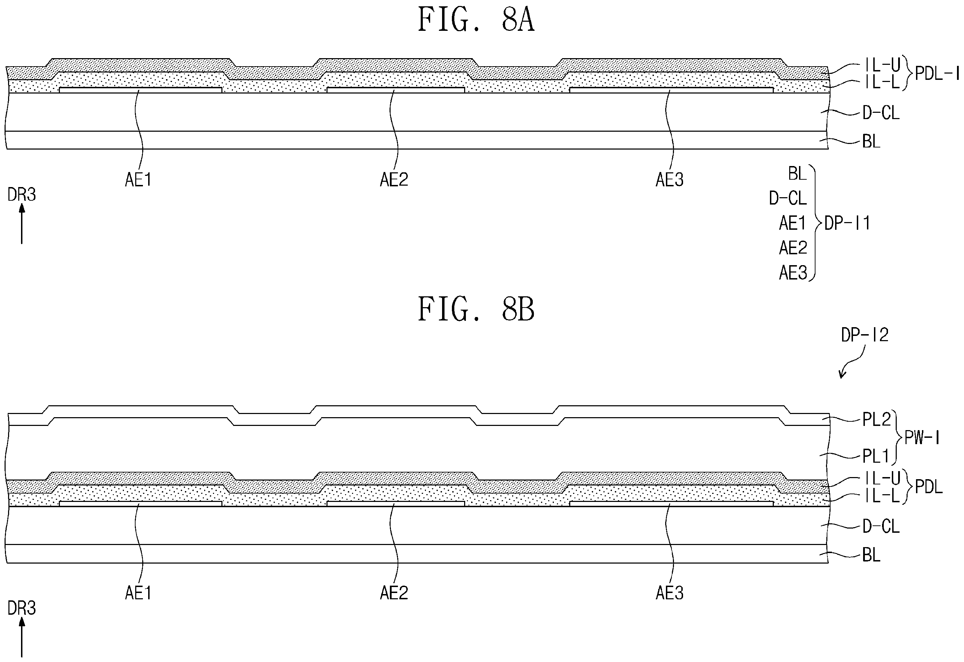

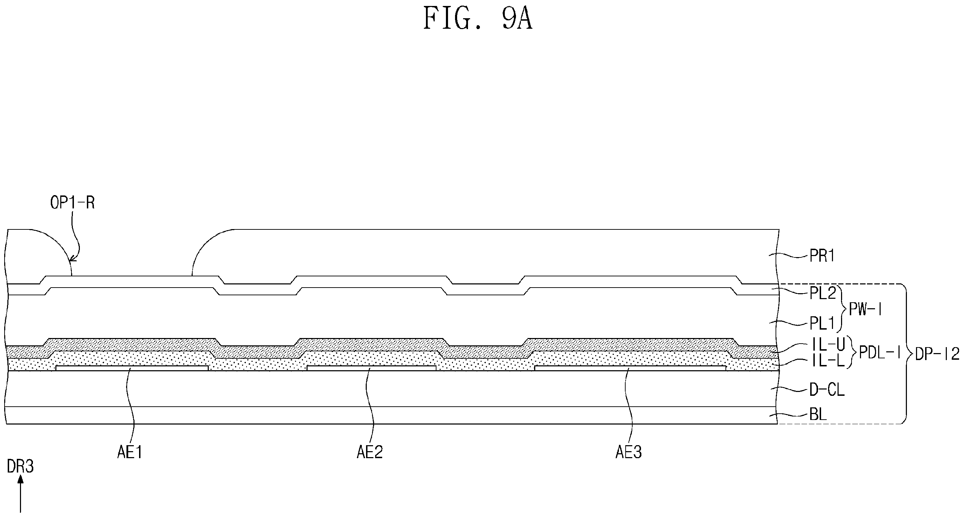

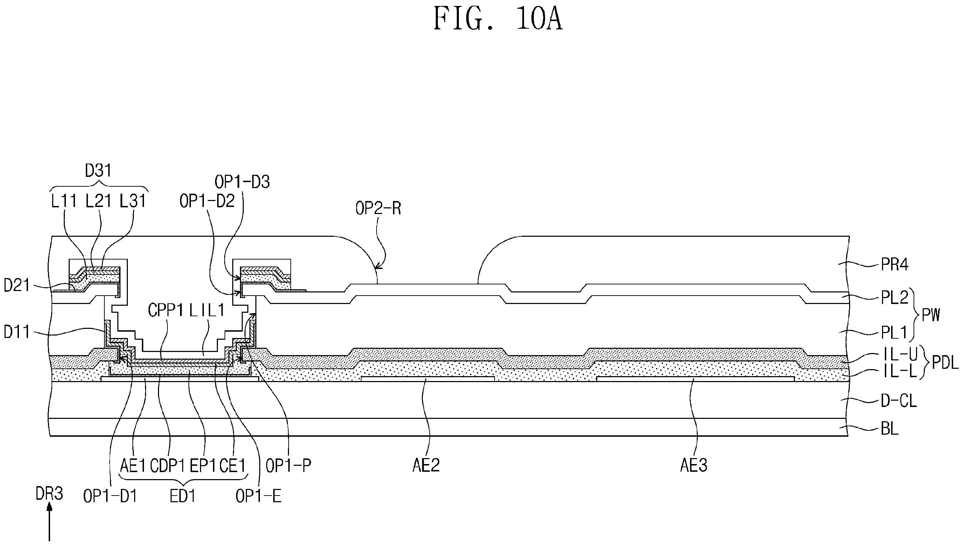

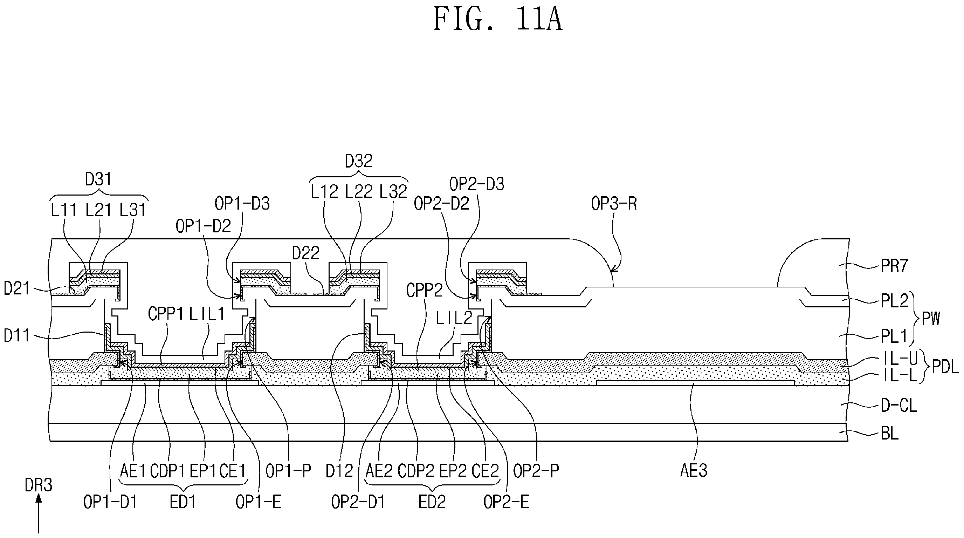

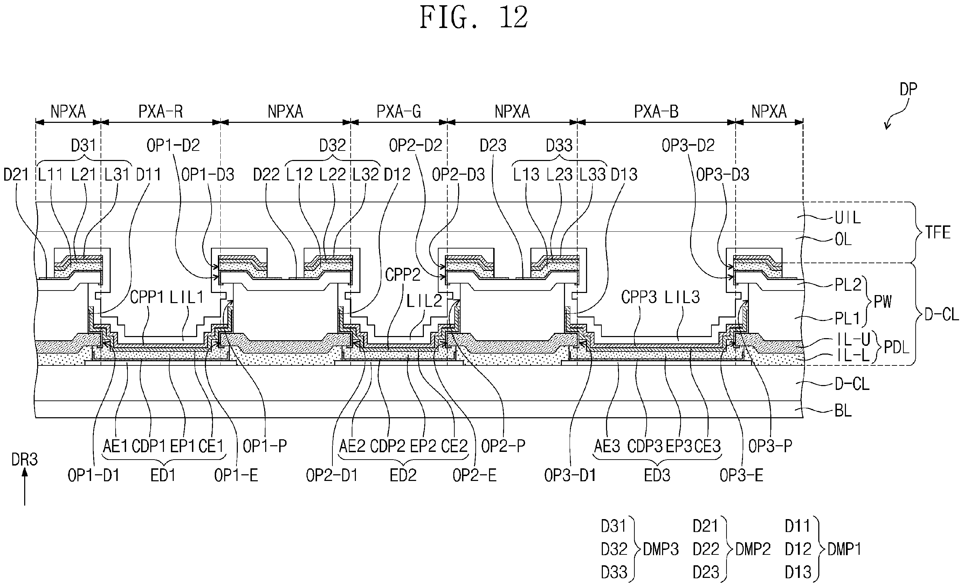

FIGS. 8A and 8B are sectional views illustrating some of processes of a display panel manufacturing method according to an embodiment of the disclosure. FIGS. 9A to 9I are sectional views illustrating other processes of the display panel manufacturing method according to an embodiment of the disclosure. FIGS. 10A to 10G are sectional views illustrating other processes of the display panel manufacturing method according to an embodiment of the disclosure. FIGS. 11A to 11G are sectional views illustrating other processes of the display panel manufacturing method according to an embodiment of the disclosure. FIG. 12 is a sectional view illustrating the other processes of the display panel manufacturing method according to an embodiment of the disclosure. In describing FIGS. 8A to 12, components identical/similar to the components described with reference to FIGS. 1A to 6 will be assigned with identical/similar reference numerals, and any repetitive detailed descriptions thereof will be omitted.

The display panel manufacturing method (i.e., a method of manufacturing a display panel) according to an embodiment of the disclosure includes a process of providing a preliminary display panel including a base layer and a first anode disposed on the base layer, a process of forming, on the base layer, a preliminary pixel defining layer including a lower insulating layer including a first insulating material and an upper insulating layer including a second insulating material different from the first insulating material, a process of forming a preliminary partition wall on the preliminary pixel defining layer, a process of making the preliminary partition wall subject to patterning (or patterning the preliminary partition wall) to form a partition wall with a first partition wall opening defined therein, a process of making the preliminary pixel defining layer subject to patterning to form a pixel defining layer with a first light emitting opening defined therein to expose at least a portion of the first anode, a process of forming a first pattern covering the first anode exposed by the first light emitting opening, a process of forming a first emission pattern on the first pattern, and a process of forming, on the first emission pattern, a first cathode at least partially disposed in the first partition wall opening.

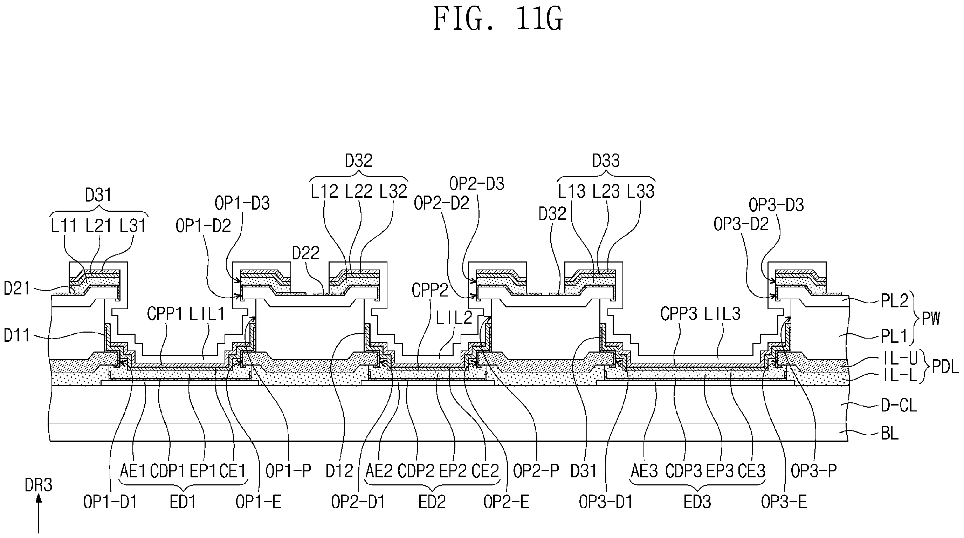

The display panel manufacturing method according to an embodiment of the disclosure may include a first group of processes, a second group of processes, a third group of processes, a fourth group of processes, and a fifth group of processes. The first group of processes may be processes of preparing a preliminary display panel DP-I2 (refer to FIG. 8B) including a preliminary partition wall PW-I (refer to FIG. 8B), the second to fourth groups of processes may be processes of forming first to third light emitting elements ED1, ED2, and ED3 (refer to FIG. 11G) and some components of an encapsulation layer TFE (refer to FIG. 12), and the fifth group of processes may be processes of completing a display panel DP (refer to FIG. 12) by forming the remaining components of the encapsulation layer TFE (refer to FIG. 12).

First, the first group of processes will be described with reference to FIGS. 8A and 8B.

Referring to FIG. 8A, the first group of processes according to an embodiment may include a process of forming, on a first preliminary display panel DP-I1, a preliminary pixel defining layer PDL-I including a lower insulating layer ILL and an upper insulating layer IL-U. In such an embodiment, the first preliminary display panel DP-I1 may include a base layer BL, a circuit element layer D-CL, and first to third anodes AE1, AE2, and AE3.

The circuit element layer D-CL may be formed through a conventional circuit element manufacturing process of forming an insulating layer, a semiconductor layer, and a conductive layer by coating, deposition, or the like and forming a semiconductor pattern, a conductive pattern, and a signal line by selectively making the insulating layer, the semiconductor layer, and the conductive layer subject to patterning by photolithography and etching processes. The first to third anodes AE1, AE2, and AE3 may be formed in a pattern form through deposition and patterning processes.

The preliminary pixel defining layer PDL-I may be formed on the uppermost insulating layer (e.g., the fifth insulating layer 50 (refer to FIG. 5)) among insulating layers of the circuit element layer D-CL and may cover the first to third anodes AE1, AE2, and AE3.

The process of forming the preliminary pixel defining layer PDL-I may include a process of forming the lower insulating layer IL-L including a first insulating material and a process of forming, on the lower insulating layer IL-L, the upper insulating layer IL-U including a second insulating material different from the first insulating material.

The process of forming the lower insulating layer IL-L may be performed through a deposition process of the first insulating material, and the process of forming the upper insulating layer IL-U may be performed through a deposition process of the second insulating material. In an embodiment, both the first insulating material and the second insulating material may be inorganic insulating materials. In an embodiment, for example, the first insulating material may include silicon nitride (SiNₓ), and the second insulating material may include silicon oxide (SiOₓ). The process of forming the lower insulating layer IL-L and the process of forming the upper insulating layer IL-U may be performed through a chemical vapor deposition (CVD) process.

Referring to FIG. 8B, the display panel manufacturing method according to an embodiment may further include a process of forming the preliminary partition wall PW-I on the preliminary pixel defining layer PDL-I.

The process of forming the preliminary partition wall PW-I may include a process of forming a first partition wall layer PL1 including a first conductive material on the preliminary pixel defining layer PDL-I and a process of forming a second partition wall layer PL2 including a second conductive material. The first conductive material may have first conductivity, and the second conductive material may have second conductivity lower than the first conductivity.

The process of forming the first partition wall layer PL1 may be performed through a deposition process of the first conductive material. In an embodiment, the first conductive material may include metal, transparent conductive oxide (TCO), or a combination thereof. In an embodiment, for example, the metal may include gold (Au), silver (Ag), aluminum (Al), magnesium (Mg), lithium (Li), molybdenum (Mo), titanium (Ti), copper (Cu), or an alloy thereof. The transparent conductive oxide may include indium tin oxide (ITO), indium zinc oxide (IZO), zinc oxide, indium oxide, indium gallium oxide, indium gallium zinc oxide (IGZO), or aluminum zinc oxide. In an embodiment, for example, the process of forming the first partition wall layer PL1 may be performed through a sputtering deposition process, but is not limited thereto.

The process of forming the second partition wall layer PL2 may be performed through a deposition process of the second conductive material. In an embodiment, the second conductive material may include metal, metal oxide, metal nitride, or non-metal. In an embodiment, for example, the metal may include gold (Au), silver (Ag), aluminum (Al), magnesium (Mg), lithium (Li), molybdenum (Mo), titanium (Ti), copper (Cu), or an alloy thereof. The metal oxide may include transparent conductive oxide (TCO). The non-metal may include silicon (Si), silicon oxide (SiOₓ), silicon nitride (SiNₓ), silicon oxy-nitride (SiON), or a combination thereof. In an embodiment, for example, the process of forming the second partition wall layer PL2 may be performed through a sputtering deposition process, but is not limited thereto.

The preliminary display panel DP-I2, which includes the base layer BL, the circuit element layer D-CL, the first to third anodes AE1, AE2, and AE3, the preliminary pixel defining layer PDL-I, and the preliminary partition wall PW-I, may be formed through the first group of processes.

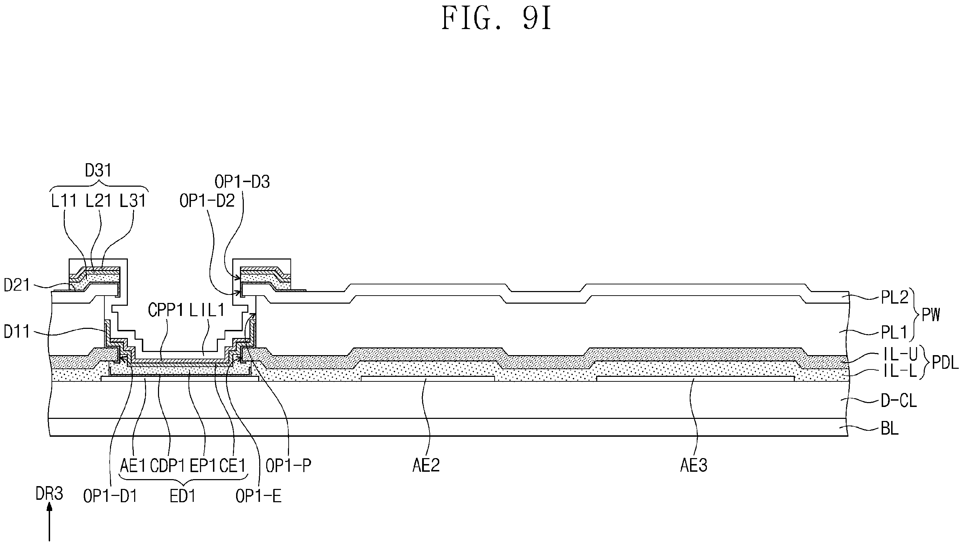

The second group of processes may be performed after the first group of processes. In an embodiment, the first light emitting element ED1 (refer to FIG. 9I) and a first lower inorganic encapsulation pattern LIL1 (refer to FIG. 9I) that covers the first light emitting element ED1 may be formed through the second group of processes. Hereinafter, the second group of processes will be described with reference to FIGS. 9A to 9I.

Referring to FIG. 9A, the second group of processes according to an embodiment may include a process of forming a first photoresist layer PR1 on the preliminary display panel DP-I2 formed through the first group of processes.

The first photoresist layer PR1 may be formed by forming a preliminary photoresist layer on the preliminary partition wall PW-I and thereafter making the preliminary photoresist layer subject to patterning by using a photo mask. Through the patterning process, a first photo opening OP1-R overlapping the first anode AE1 may be formed in the first photoresist layer PR1.

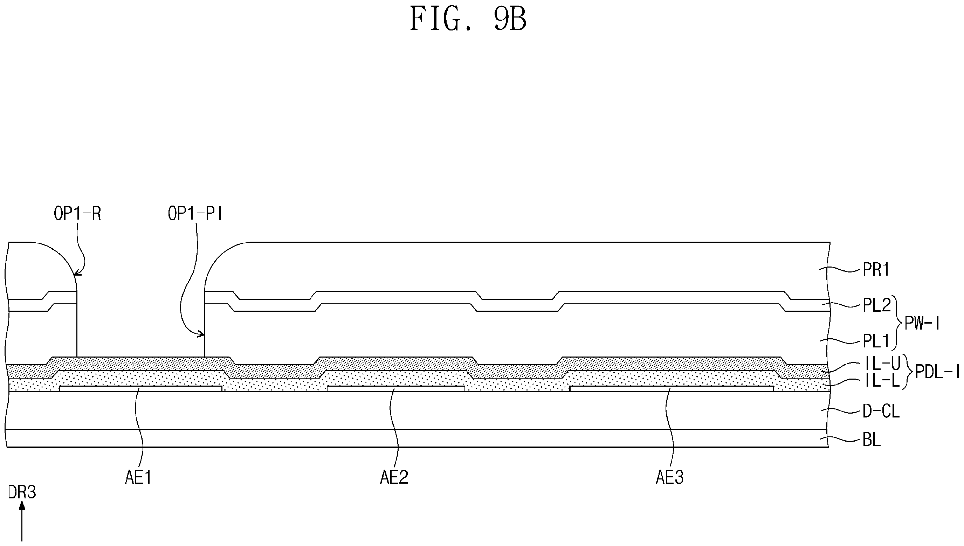

Referring to FIGS. 9B and 9C, the second group of processes according to an embodiment may further include a process of making the preliminary partition wall PW-I subject to patterning to form a partition wall PW with a first partition wall opening OP1-P defined therein from the preliminary partition wall PW-I. The process of making the preliminary partition wall PW-I subject to patterning may be performed through a first etching process and a second etching process.

As illustrated in FIG. 9B, the process of making the preliminary partition wall PW-I subject to patterning may include a first etching process of firstly etching the first and second partition wall layers PL1 and PL2. In the first etching process, a first preliminary partition wall opening OP1-PI may be formed in the preliminary partition wall PW-I by using the first photoresist layer PR1 as a mask. The first etching process may be performed through a dry etching process.

The first etching process in an embodiment may be performed in an etching environment in which the etch selectivity between the first and second partition wall layers PL1 and PL2 is substantially the same as each other. Accordingly, an inner surface of the first partition wall layer PL1 and an inner surface of the second partition wall layer PL2 that define the first preliminary partition wall opening OP1-PI may be substantially aligned with each other.

As illustrated in FIG. 9C, the process of making the preliminary partition wall PW-I subject to patterning may include a second etching process of secondly etching the first and second partition wall layers PL1 and PL2. In the second etching process, the first partition wall opening OP1-P may be formed from the first preliminary partition wall opening OP1-PI by using the first photoresist layer PR1 as a mask. The second etching process may be performed through a wet etching process.

The second etching process in an embodiment may be performed in an environment in which the etch selectivity between the first and second partition wall layers PL1 and PL2 is high. Accordingly, an inner surface of the partition wall PW that defines the first partition wall opening OP1-P may have an undercut shape on the section.

In an embodiment, in the second etching process, the first partition wall layer PL1 may be mainly etched since the etch rate of the first partition wall layer PL1 by an etching solution is higher than the etch rate of the second partition wall layer PL2 by the etching solution. In such an embodiment, depending on conditions of the second etching process, the second partition wall layer PL2 may be partially etched together with the first partition wall layer PL1, or the second partition wall layer PL2 may not be etched. In an embodiment in which the second partition wall layer PL2 is not etched, in the process of making the preliminary partition wall PW-I subject to patterning, a process of secondly etching only the first partition wall layer PL1 may be performed after the first etching process of firstly etching the first and second partition wall layers PL1 and PL2.

The first partition wall opening OP1-P may include a second lower region LA2 and a second upper region UA2 sequentially disposed in a thickness direction (that is, the third direction DR3). The first partition wall layer PL1 may include a first partition wall inner surface S-P1 that defines the second lower region LA2 of the first partition wall opening OP1-P, and the second partition wall layer PL2 may include a second partition wall inner surface S-P2 that defines the second upper region UA2 of the first partition wall opening OP1-P.

Through an etching process, the first partition wall inner surface S-P1 may be formed to be recessed in a direction away from the center of the first anode AE1 when compared to the second partition wall inner surface S-P2. Accordingly, on the section, the width W2 of the second upper region UA2 in the one direction may be smaller than the width W1 of the second lower region LA2 in the one direction. A second tip portion TP2 may be formed in the partition wall PW by a portion of the second partition wall layer PL2 that protrudes from the first partition wall layer PL1.

Referring to FIGS. 9C and 9D, the second group of processes according to an embodiment may further include a process of making the preliminary pixel defining layer PDL-I subject to patterning to form a pixel defining layer PDL with a first light emitting opening OP1-E defined therein.

The process of making the preliminary pixel defining layer PDL-I subject to patterning may include a third etching process of etching the lower insulating layer IL-L and the upper insulating layer IL-U. In the third etching process, the pixel defining layer PDL with the first light emitting opening OP1-E defined therein may be formed by using the first photoresist layer PR1 as a mask. The third etching process may be performed through a dry etching process.

The third etching process in an embodiment may be performed in an environment in which the etch selectivity between the lower insulating layer IL-L and the upper insulating layer IL-U is high. Accordingly, inner surfaces of the pixel defining layer PDL that define the first light emitting opening OP1-E may have an undercut shape on the section. In an embodiment, in the third etching process, the lower insulating layer IL-L may be etched further than the upper insulating layer IL-U since the etch rate of the lower insulating layer IL-L by an etching gas is higher than the etch rate of the upper insulating layer IL-U by the etching gas.

The first light emitting opening OP1-E may include a first lower region LA1 and a first upper region UA1 sequentially disposed in the thickness direction (that is, the third direction DR3). The lower insulating layer IL-L may include a lower inner surface S-L that defines the first lower region LA1 of the first light emitting opening OP1-E, and the upper insulating layer IL-U may include an upper inner surface S-U that defines the first upper region UA1 of the first light emitting opening OP1-E.

Through an etching process, the lower inner surface S-L may be formed to be recessed in a direction away from the center of the first anode AE1 when compared to the upper inner surface S-U. Accordingly, on the section, the width Wu of the first upper region UA1 in the one direction may be smaller than the width Wl of the first lower region LA1 in the one direction. A first tip portion TP1 may be formed in the pixel defining layer PDL by a portion of the upper insulating layer IL-U that protrudes from the lower insulating layer IL-L.

In an embodiment, through the third etching process, at least a portion of an upper surface of the first anode AE1 may be exposed by the pixel defining layer PDL by the first light emitting opening OP1-E, and a region of the first anode AE1 exposed by the first upper region UA1 of the first light emitting opening OP1-E may be defined as a first emissive region PXA-R (refer to FIG. 6).

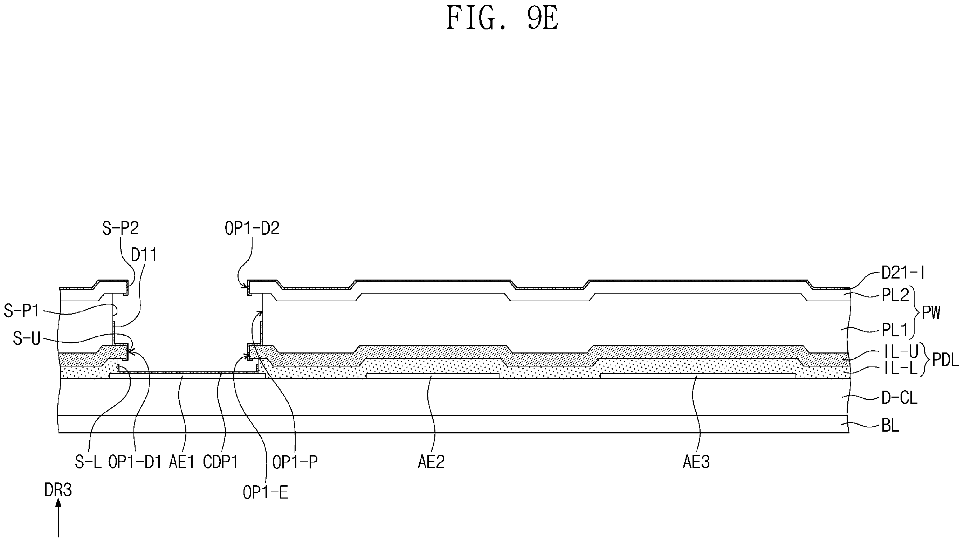

Referring to FIGS. 9D and 9E, the second group of processes according to an embodiment may further include a process of removing the first photoresist layer PR1.

Referring to FIG. 9E, the second group of processes according to an embodiment may further include a process of forming a first conductive pattern CDP1.

In an embodiment, the first conductive pattern CDP1 may be formed through a deposition process of a third conductive material. In such an embodiment, the third conductive material may include transparent conductive oxide (TCO). In an embodiment, for example, the third conductive material may include at least one selected from indium tin oxide (ITO), indium zinc oxide (IZO), and indium gallium zinc oxide (IGZO). In an embodiment, for example, the process of forming the first conductive pattern CDP1 may be performed through a sputtering process.

In the process of forming the first conductive pattern CDP1, the first conductive pattern CDP1 may be separated by the first tip portion TP1 (refer to FIG. 9D) and the second tip portion TP2 (refer to FIG. 9D) and may be disposed in the first lower region LA1 (refer to FIG. 9D) of the first light emitting opening OP1-E. The first conductive pattern CDP1 may cover the portion of the upper surface of the first anode AE1 exposed by the first light emitting opening OP1-E.

In the process of forming the first conductive pattern CDP1, a dummy pattern 1-1 D11 and a preliminary dummy pattern 2-1 D21-I may be formed together. The dummy pattern 1-1 D11 may be separated from the first conductive pattern CDP1 by the first tip portion TP1 (refer to FIG. 9D) and thus may be spaced apart from the first conductive pattern CDP1.

The dummy pattern 1-1 D11 may cover the upper inner surface S-U that defines the first upper region UA1 (refer to FIG. 9D) of the first light emitting opening OP1-E and the first partition wall inner surface S-P1 that defines the second lower region LA2 (refer to FIG. 9C) of the first partition wall opening OP1-P. A dummy opening 1-1 OP1-D1 disposed in the first partition wall opening OP1-P and the first light emitting opening OP1-E may be defined in the dummy pattern 1-1 D11.

The preliminary dummy pattern 2-1 D21-I may cover the upper surface of the second partition wall layer PL2 and the second partition wall inner surface S-P2 that defines the second upper region UA2 (refer to FIG. 9C) of the first partition wall opening OP1-P. A dummy opening 2-1 OP1-D2 in the first partition wall opening OP1-P may be defined in the preliminary dummy pattern 2-1 D21-I.

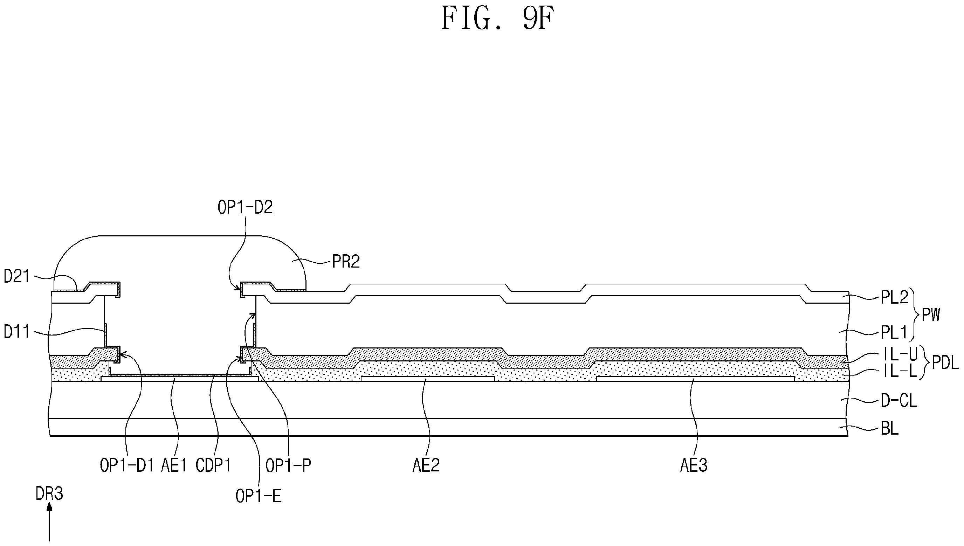

Referring to FIGS. 9E and 9F, the second group of processes according to an embodiment may further include a process of forming a second photoresist layer PR2 on the preliminary dummy pattern 2-1 D21-I. The second photoresist layer PR2 may be formed in a pattern form overlapping the first anode AE1 and the first light emitting opening OP1-E and may be formed not to overlap the second and third anodes AE2 and AE3.

The second group of processes according to an embodiment may further include a process of making the preliminary dummy pattern 2-1 D21-I subject to patterning to form a dummy pattern 2-1 D21.

The process of making the preliminary dummy pattern 2-1 D21-I subject to patterning may include a fourth etching process of etching the preliminary dummy pattern 2-1 D21-I. In the fourth etching process, portions of the preliminary dummy pattern 2-1 D21-I that overlap the second and third anodes AE2 and AE3 may be removed by using the second photoresist layer PR2 as a mask. Accordingly, the dummy pattern 2-1 D21 with the dummy opening 2-1 OP1-D2 defined therein may be formed. The dummy pattern 2-1 D21 may be formed in a closed-line form extending along the outer boundary of the first emissive region PXA-R (refer to FIG. 6) on the plane and may not overlap the second and third anodes AE2 and AE3. The fourth etching process may be performed through a wet etching process, but is not limited thereto.

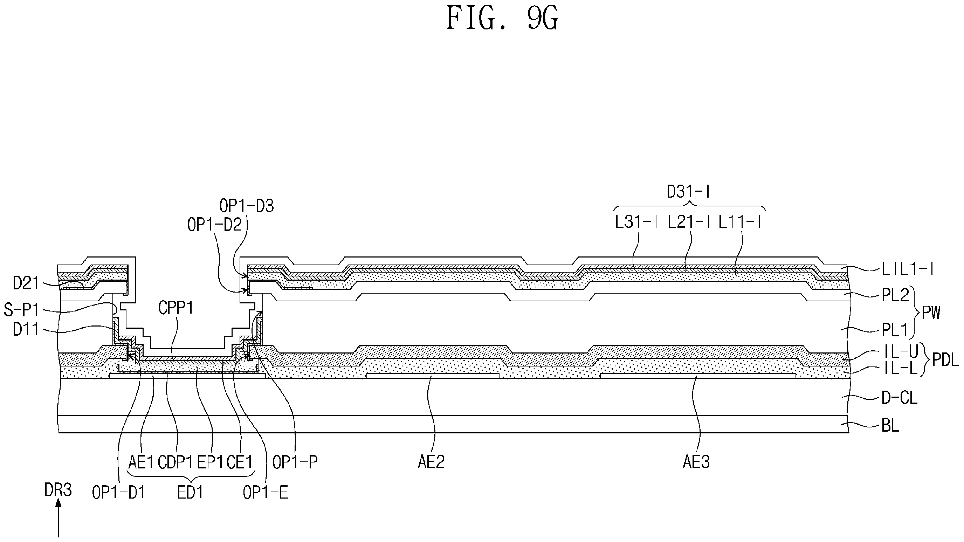

Referring to FIGS. 9F and 9G, the second group of processes according to an embodiment may further include a process of removing the second photoresist layer PR2.

Referring to FIG. 9G, the second group of processes according to an embodiment may further include a process of forming a first emission pattern EP1, a process of forming a first cathode CE1, a process of forming a first capping pattern CPP1, and a process of forming a first preliminary lower inorganic encapsulation pattern LII,1-I. Alternatively, the process of forming the first capping pattern CPP1 may be omitted.

The process of forming the first emission pattern EP1 may be performed by depositing a first organic material. In an embodiment, for example, the first emission pattern EP1 may be formed by a thermal evaporation process, but is not limited thereto. The process of forming the first cathode CE1 may be performed by depositing a fourth conductive material. The fourth conductive material may include metal, transparent conductive oxide (TCO), or a conductive polymer material. In an embodiment, for example, the first cathode CE1 may be formed through a sputtering process, but is not limited thereto.

The first emission pattern EP1 may be separated by the undercut shape of the partition wall PW, and at least a portion of the first emission pattern EP1 may be disposed in the first light emitting opening OP1-E. In some embodiments, the first emission pattern EP1 may be disposed in the first partition wall opening OP1-P. In the process of forming the first emission pattern EP1, a preliminary dummy layer 1-1 L11-I may be formed together on the partition wall PW.

The first cathode CE1 may be separated by the undercut shape of the partition wall PW and may be disposed in the first light emitting opening OP1-E and the first partition wall opening OP1-P. The first cathode CE1 may be provided at a higher incident angle than the first emission pattern EP1 and thus may make contact with the first partition wall inner surface S-P1 of the first partition wall layer PL1. In the process of forming the first cathode CE1, a preliminary dummy layer 2-1 L21-I may be formed together on the partition wall PW.

The first anode AE1, the first conductive pattern CDP1, the first emission pattern EP1, and the first cathode CE1 may constitute the first light emitting element ED1.

The process of forming the first capping pattern CPP1 may be performed through a deposition process, but is not limited thereto.

The first capping pattern CPP1 may be separated by the undercut shape of the partition wall PW and may be disposed in the first light emitting opening OP1-E and the first partition wall opening OP1-P. In the process of forming the first capping pattern CPP1, a preliminary dummy layer 3-1 L31-I may be formed together on the partition wall PW.

The preliminary dummy layers 1-1 L11-I, 2-1 L21-I, and 3-1 L31-I may constitute a preliminary dummy pattern 3-1 D31-I. A dummy opening 3-1 OP1-D3 corresponding to the first partition wall opening OP1-P and the dummy opening 2-1 OP1-D2 may be defined in the preliminary dummy pattern 3-1 D31-I. The dummy opening 3-1 OP1-D3 may be defined by inner surfaces of the preliminary dummy layers 1-1 L11-I, 2-1 L21-I, and 3-1 L31-I.

The process of forming the first preliminary lower inorganic encapsulation pattern LIL1-I may be performed by depositing an inorganic material. In an embodiment, for example, the first preliminary lower inorganic encapsulation pattern LIL1-I may be formed through a chemical vapor deposition (CVD) process, but is not limited thereto.

One portion of the first preliminary lower inorganic encapsulation pattern LIL1-I may cover the first cathode CE1 in the first partition wall opening OP1-P, and another portion of the first preliminary lower inorganic encapsulation pattern LIL1-I may cover the preliminary dummy pattern 3-1 D31-I on the partition wall PW.

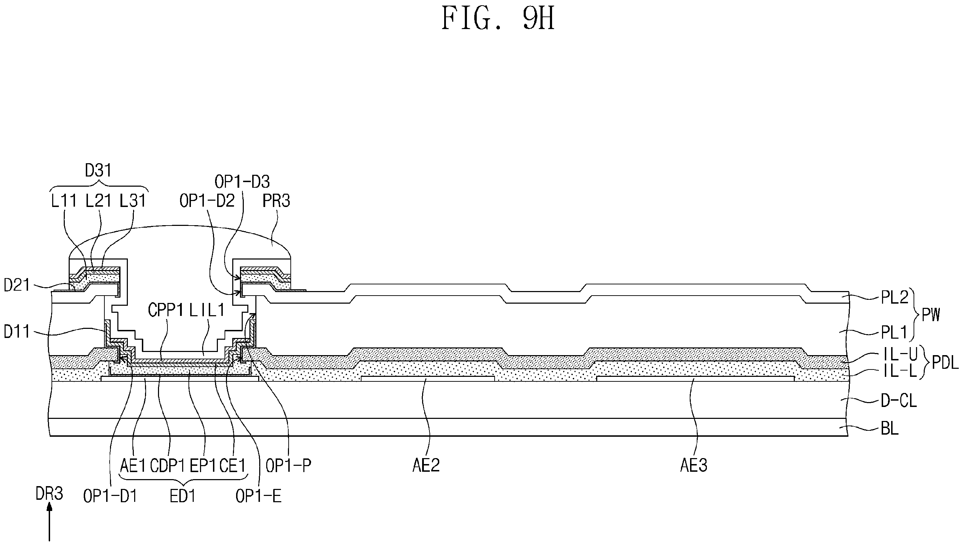

Referring to FIGS. 9G and 9H, the second group of processes according to an embodiment may further include a process of forming a third photoresist layer PR3 on the first preliminary lower inorganic encapsulation pattern LIL1-I. The third photoresist layer PR3 may be formed in a pattern form overlapping the first anode AE1 and the first light emitting opening OP1-E and may be formed not to overlap the second and third anodes AE2 and AE3.

The second group of processes according to this embodiment may include a process of making the first preliminary lower inorganic encapsulation pattern LIL1-I subject to patterning to form the first lower inorganic encapsulation pattern LIL1 and a process of making the preliminary dummy pattern 3-1 D31-I subject to patterning to form a dummy pattern 3-1 D31.

The process of making the first preliminary lower inorganic encapsulation pattern LIL1-I subject to patterning may include a fifth etching process of etching the first preliminary lower inorganic encapsulation pattern LII,1-I. In the fifth etching process, portions of the first preliminary lower inorganic encapsulation pattern LIL1-I that overlap the second and third anodes AE2 and AE3 may be removed by using the third photoresist layer PR3 as a mask. Accordingly, the first lower inorganic encapsulation pattern LIL1 may be formed. The first lower inorganic encapsulation pattern LIL1 may be formed in a pattern form disposed on the first cathode CE1 and portions of the partition wall PW that are adjacent to the first partition wall opening OP1-P and may not overlap the second and third anodes AE2 and AE3. The fifth etching process may be performed through a dry etching process, but is not limited thereto.

The process of making the preliminary dummy pattern 3-1 D31-I subject to patterning may include a sixth etching process of etching the preliminary dummy pattern 3-1 D31-I. In the sixth etching process, the dummy pattern 3-1 D31 may be formed by removing portions of the preliminary dummy pattern 3-1 D31-I overlapping the second and third anodes AE2 and AE3 by using the third photoresist layer PR3 as a mask.

In an embodiment, dummy layers 1-1 L11, 2-1 L21, and 3-1 L31 may be formed from the preliminary dummy layers 1-1 L11-I, 2-1 L21-I, and 3-1 L31-I by removing portions of the preliminary dummy layers 1-1 L11-I, 2-1 L21-I, and 3-1 L31-I that overlap the second and third anodes AE2 and AE3. The dummy layers 1-1 L11, 2-1 L21, and 3-1 L31 may constitute the dummy pattern 3-1 D31, and the dummy opening 3-1 OP1-D3 may be defined in the dummy pattern 3-1 D31. The dummy pattern 3-1 D31 may be formed in a closed-curve form extending along the outer boundary of the first emissive region PXA-R (refer to FIG. 4) on the plane and may not overlap the second and third anodes AE2 and AE3.

The etching process may be performed through a dry etching process, but is not limited thereto. In an embodiment, the etching processes of the preliminary dummy layers 1-1 L11-I, 2-1 L21-I, and 3-1 L31-I may be performed through one etching process, or may be performed through separate etching processes.

Referring to FIGS. 9H and 9I, the second group of processes according to an embodiment may further include a process of removing the third photoresist layer PR3 .

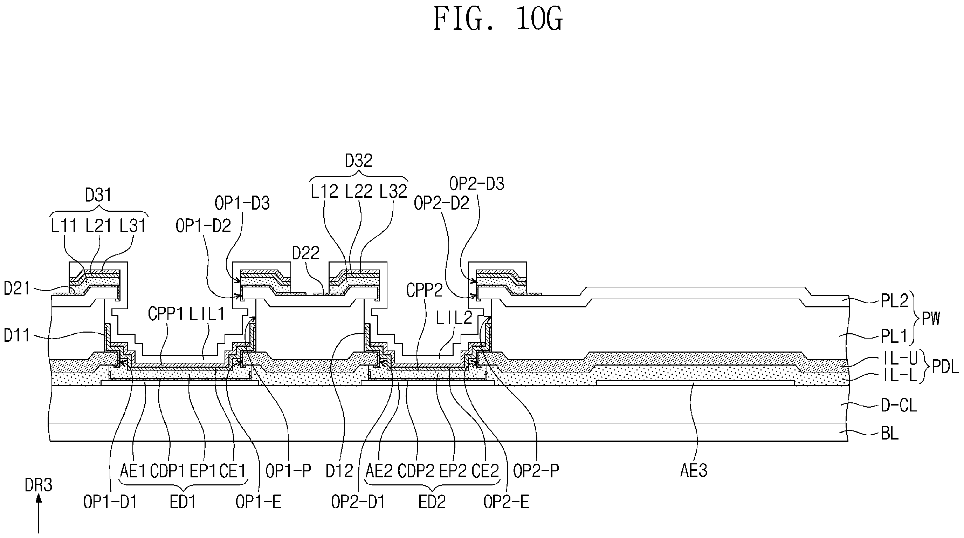

The third group of processes may be performed after the second group of processes. In an embodiment, the second light emitting element ED2 (refer to FIG. 10G) and a second lower inorganic encapsulation pattern LIL2 (refer to FIG. 10G) that covers the second light emitting element ED2 may be formed through the third group of processes. Hereinafter, the third group of processes will be described with reference to FIGS. 10A to 10G.

Referring to FIG. 10A, the third group of processes according to an embodiment may include a process of forming a fourth photoresist layer PR4 on the partition wall PW. A second photo opening OP2-R overlapping the second anode AE2 may be defined in the fourth photoresist layer PR4.

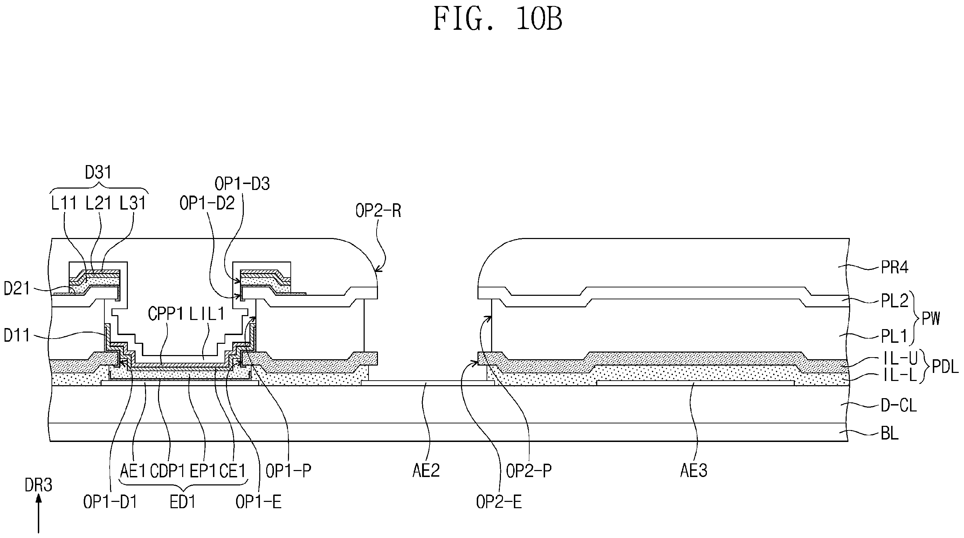

Referring to FIG. 10B, the third group of processes according to an embodiment may further include a process of forming a second partition wall opening OP2-P in the partition wall PW and a process of forming a second light emitting opening OP2-E in the pixel defining layer PDL.

The process of forming the second partition wall opening OP2-P in the partition wall PW may be performed through a first etching process and a second etching process. The descriptions of the first and second etching processes in the second group of processes described above with reference to FIGS. 9B and 9C may be similarly applied to the first and second etching processes in the third group of processes.

The first etching process in the third group of processes may be performed through a dry etching process of the first and second partition wall layers PL1 and PL2 by using the fourth photoresist layer PR4 as a mask.

The second etching process in the third group of processes may be performed through a wet etching process of the first and second partition wall layers PL1 and PL2 by using the fourth photoresist layer PR4 as a mask. The partition wall PW that defines the second partition wall opening OP2-P may have an undercut shape on the section.

The process of forming the second light emitting opening OP2-E in the pixel defining layer PDL may be performed through a third etching process. The description of the third etching process in the second group of processes described above with reference to FIG. 9D may be similarly applied to the third etching process in the third group of processes.

The third etching process in the third group of processes may be performed through a dry etching process of the lower insulating layer IL-L and the upper insulating layer IL-U by using the fourth photoresist layer PR4 as a mask. The pixel defining layer PDL that defines the second light emitting opening OP2-E may have an undercut shape on the section.

At least a portion of the second anode AE2 may be exposed by the second partition wall opening OP2-P and the second light emitting opening OP2-E, and a region of the second anode AE2 exposed by the first upper region UA1 (refer to FIG. 9D) of the second light emitting opening OP2-E may be defined as a second emissive region PXA-G (refer to FIG. 6).

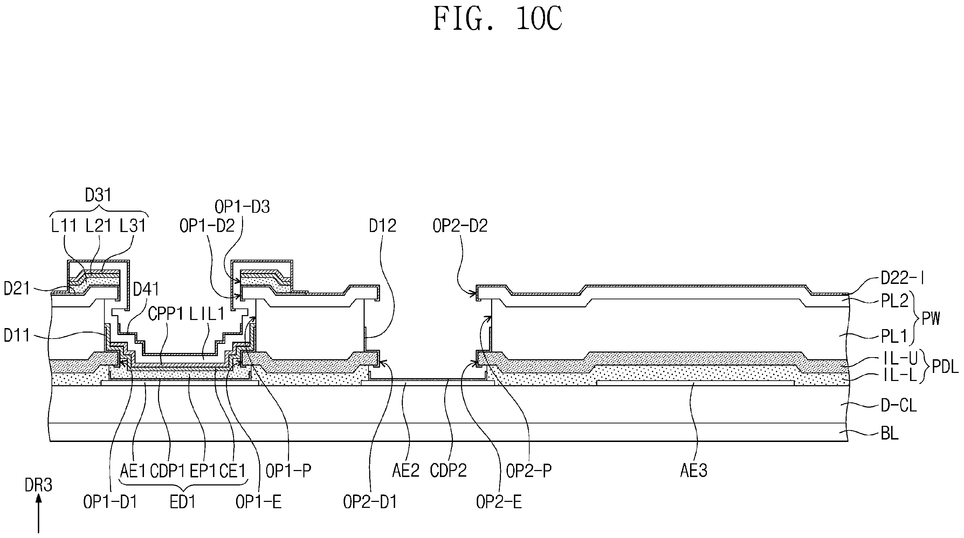

Referring to FIGS. 10B and 10C, the third group of processes according to an embodiment may further include a process of removing the fourth photoresist layer PR4.

Referring to FIG. 10C, the third group of processes according to this embodiment may further include a process of forming a second conductive pattern CDP2.

The process of forming the second conductive pattern CDP2 may be performed in a manner similar to the process of forming the first conductive pattern CDP1 in the second group of processes described above with reference to FIG. 9E. The second conductive pattern CDP2 may be formed through a deposition process of the third conductive material. In an embodiment, for example, the process of forming the second conductive pattern CDP2 may be performed through a sputtering process.

In the process of forming the second conductive pattern CDP2, a dummy pattern 1-2 D12 spaced apart from the second conductive pattern CDP2, a preliminary dummy pattern 2-2 D22-I, and a dummy pattern 4-1 D41 may be formed together.

The dummy pattern 1-2 D12 may be disposed in the second light emitting opening OP2-E and the second partition wall opening OP2-P. A dummy opening 1-2 OP2-D1 may be defined in the dummy pattern 1-2 D12.

One portion of the preliminary dummy pattern 2-2 D22-I may be disposed on the second partition wall layer PL2 and the first lower inorganic encapsulation pattern LIL1, and another portion of the preliminary dummy pattern 2-2 D22-I may be disposed in the second partition wall opening OP2-P. A dummy opening 2-2 OP2-D2 may be defined in the preliminary dummy pattern 2-2 D22-I.

The dummy pattern 4-1 D41 may be separated from the preliminary dummy pattern 2-2 D22-I and may be disposed on the first lower inorganic encapsulation pattern LIL1 in the first partition wall opening OP1-P. In an embodiment of the disclosure, the separate dummy pattern 4-1 D41 may not be formed, and the preliminary dummy pattern 2-2 D22-I may be disposed in the first partition wall opening OP1-P while entirely covering the first lower inorganic encapsulation pattern LIL1.

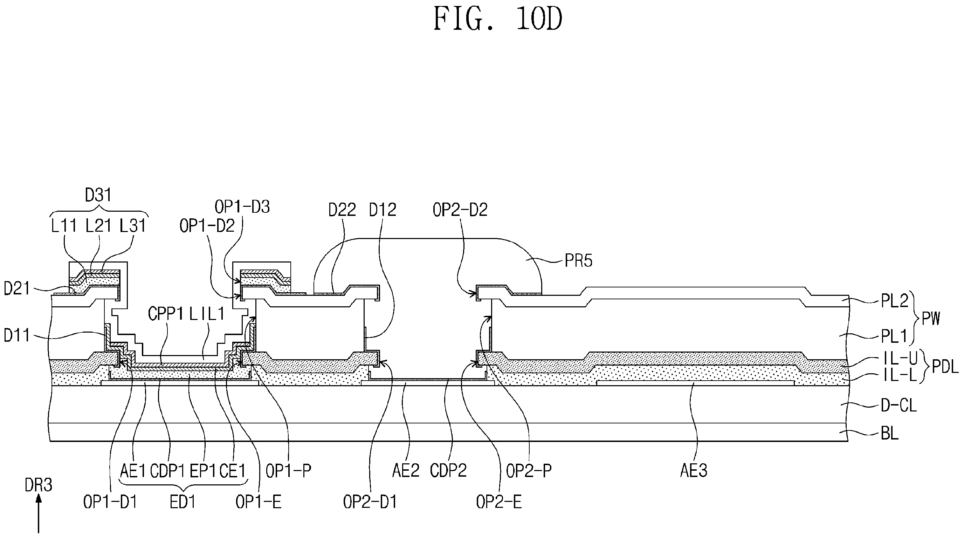

Referring to FIGS. 10C and 10D, the third group of processes according to this embodiment may include a process of forming a fifth photoresist layer PR5 on the preliminary dummy pattern 2-2 D22-I. The fifth photoresist layer PR5 may be formed in a pattern form overlapping the second anode AE2 and the second light emitting opening OP2-E and may be formed not to overlap the first and third anodes AE1 and AE3.

The third group of processes according to this embodiment may include a process of making the preliminary dummy pattern 2-2 D22-I subject to patterning to form a dummy pattern 2-2 D22. The process of making the preliminary dummy pattern 2-2 D22-I subject to patterning may be performed through a fourth etching process. The description of the fourth etching process in the second group of processes described above with reference to FIG. 9F may be similarly applied to the fourth etching process in the third group of processes.

The fourth etching process in the third group of processes may remove portions of the preliminary dummy pattern 2-2 D22-I overlapping the first and third anodes AE1 and AE3 by using the fifth photoresist layer PR5 as a mask. Accordingly, the dummy pattern 2-2 D22 with the dummy opening 2-2 OP2-D2 defined therein may be formed. In this process, the dummy pattern 4-1 D41 may be removed together.

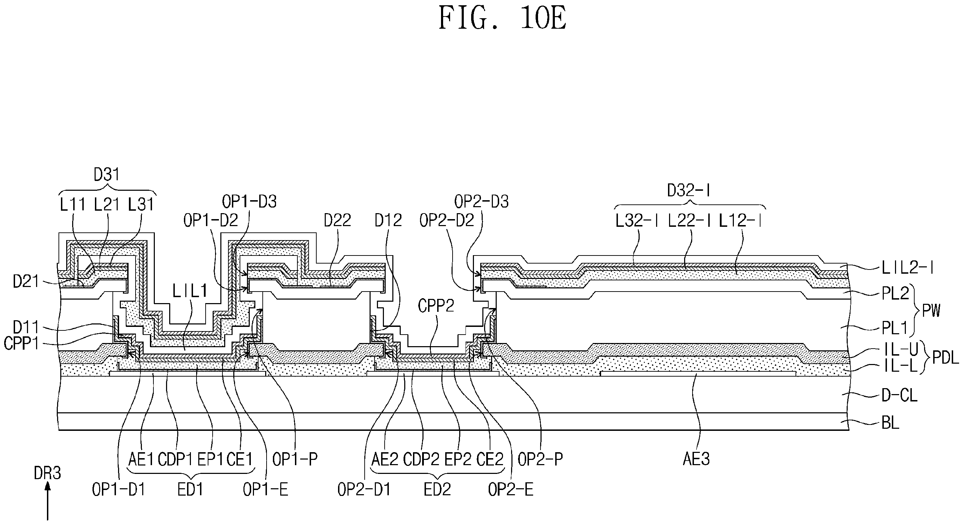

Referring to FIGS. 10D and 10E, the third group of processes according to an embodiment may further include a process of removing the fifth photoresist layer PR5.

Referring to FIG. 10E, the third group of processes according to an embodiment may further include a process of forming a second emission pattern EP2, a process of forming a second cathode CE2, a process of forming a second capping pattern CPP2, and a process of forming a second preliminary lower inorganic encapsulation pattern LIL2-I. Alternatively, the process of forming the second capping pattern CPP2 may be omitted.

The process of forming the second emission pattern EP2 may be performed in a manner similar to the process of forming the first emission pattern EP1 in the second group of processes described above with reference to FIG. 9G. In an embodiment, for example, the second emission pattern EP2 may be formed by depositing a second organic material, and the second organic material may include a material the same as the first organic material, or may include a material different from the first organic material. In the process of forming the second emission pattern EP2, a preliminary dummy layer 1-2 L12-I spaced apart from the second emission pattern EP2 may be formed together.

The process of forming the second cathode CE2 may be performed in a manner similar to the process of forming the first cathode CE1 in the second group of processes described above with reference to FIG. 9G, and a preliminary dummy layer 2-2 L22-I spaced apart from the second cathode CE2 may be formed together.

The second anode AE2, the second conductive pattern CDP2, the second emission pattern EP2, and the second cathode CE2 may constitute the second light emitting element ED2.

The process of forming the second capping pattern CPP2 may be performed in a manner similar to the process of forming the first capping pattern CPP1 in the second group of processes described above with reference to FIG. 9G, and a preliminary dummy layer 3-2 L32-I spaced apart from the second capping pattern CPP2 may be formed together.

The preliminary dummy layers 1-2 L12-I, 2-2 L22-I, and 3-2 L32-I may constitute a preliminary dummy pattern 3-2 D32-I. One portion of the preliminary dummy pattern 3-2 D32-I may be disposed on the partition wall PW, and another portion of the preliminary dummy pattern 3-2 D32-I may be disposed in the first partition wall opening OP1-P and may cover the first lower inorganic encapsulation pattern LIL1. A dummy opening 3-2 OP2-D3 may be defined in the preliminary dummy pattern 3-2 D32-I.

The second preliminary lower inorganic encapsulation pattern LIL2-I may be formed in a manner similar to the process of forming the first preliminary lower inorganic encapsulation pattern LIL1-I in the second group of processes described above with reference to FIG. 9G. One portion of the second preliminary lower inorganic encapsulation pattern LIL2-I may cover the second cathode CE2 in the second partition wall opening OP2-P, and another portion of the second preliminary lower inorganic encapsulation pattern LIL2-I may cover the preliminary dummy pattern 3-2 D32-I.

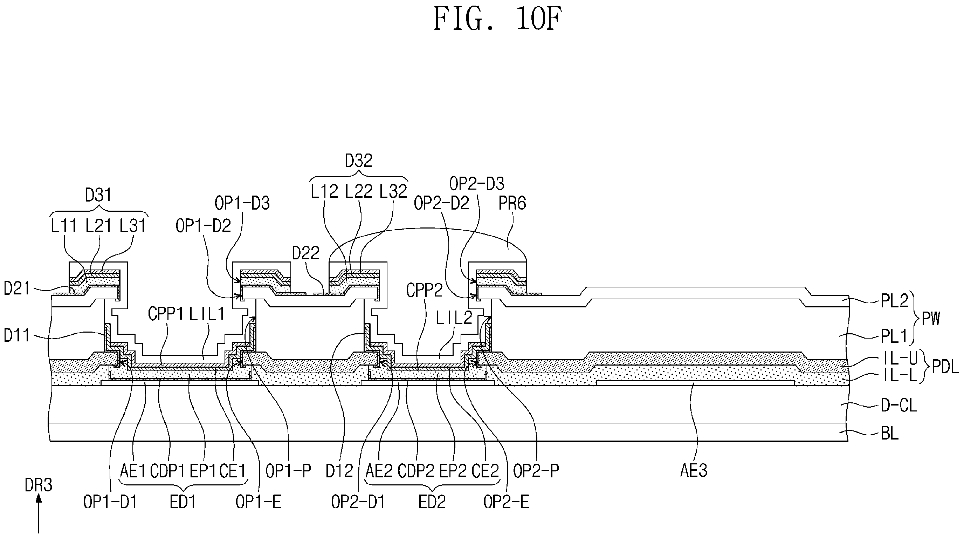

Referring to FIGS. 10E and 10F, the third group of processes according to an embodiment may further include a process of forming a sixth photoresist layer PR6 on the second preliminary lower inorganic encapsulation pattern LIL2-I. The sixth photoresist layer PR6 may be formed in a pattern form overlapping the second anode AE2 and the second light emitting opening OP2-E and may be formed not to overlap the first and third anodes AE1 and AE3.

The third group of processes according to this embodiment may include a process of making the second preliminary lower inorganic encapsulation pattern LIL2-I subject to patterning to form the second lower inorganic encapsulation pattern LIL2 and a process of making the preliminary dummy pattern 3-2 D32-I subject to patterning to form a dummy pattern 3-2 D32.

The process of making the second preliminary lower inorganic encapsulation pattern LIL2-I subject to patterning may be performed through a fifth etching process. The description of the fifth etching process in the second group of processes described above with reference to FIG. 9H may be similarly applied to the fifth etching process in the third group of processes.

The fifth etching process in the third group of processes may remove portions of the second preliminary lower inorganic encapsulation pattern LIL2-I overlapping the first and third anodes AE1 and AE3 by using the sixth photoresist layer PR6 as a mask. Accordingly, the second lower inorganic encapsulation pattern LIL2 may be formed.

The process of making the preliminary dummy pattern 3-2 D32-I subject to patterning may be performed through a sixth etching process. The description of the sixth etching process in the second group of processes described above with reference to FIG. 9H may be similarly applied to the sixth etching process in the third group of processes.

The sixth etching process in the third group of processes may remove portions of the preliminary dummy pattern 3-2 D32-I overlapping the first and third anodes AE1 and AE3 by using the sixth photoresist layer PR6 as a mask. Accordingly, the dummy pattern 3-2 D32 with the dummy opening 3-2 OP2-D3 defined therein may be formed. In an embodiment, dummy layers 1-2 L12, 2-2 L22, and 3-2 L32 may be formed by removing portions of the preliminary dummy layers 1-2 L12-I, 2-2 L22-I, and 3-2 L32-I that overlap the first and third anodes AE1 and AE3, and the dummy layers 1-2 L12, 2-2 L22, and 3-2 L32 may constitute the dummy pattern 3-2 D32.

Referring to FIGS. 10F and 10G, the third group of processes according to an embodiment may further include a process of removing the sixth photoresist layer PR6.

The fourth group of processes may be performed after the third group of processes. In an embodiment, the third light emitting element ED3 (refer to FIG. 11G) and a third lower inorganic encapsulation pattern LIL3 (refer to FIG. 11G) that covers the third light emitting element ED3 may be formed through the fourth group of processes. Hereinafter, the fourth group of processes will be described with reference to FIGS. 11A to 11G.

Referring to FIG. 11A, the fourth group of processes according to an embodiment may include a process of forming a seventh photoresist layer PR7 on the partition wall PW. A third photo opening OP3-R overlapping the third anode AE3 may be defined in the seventh photoresist layer PR7.

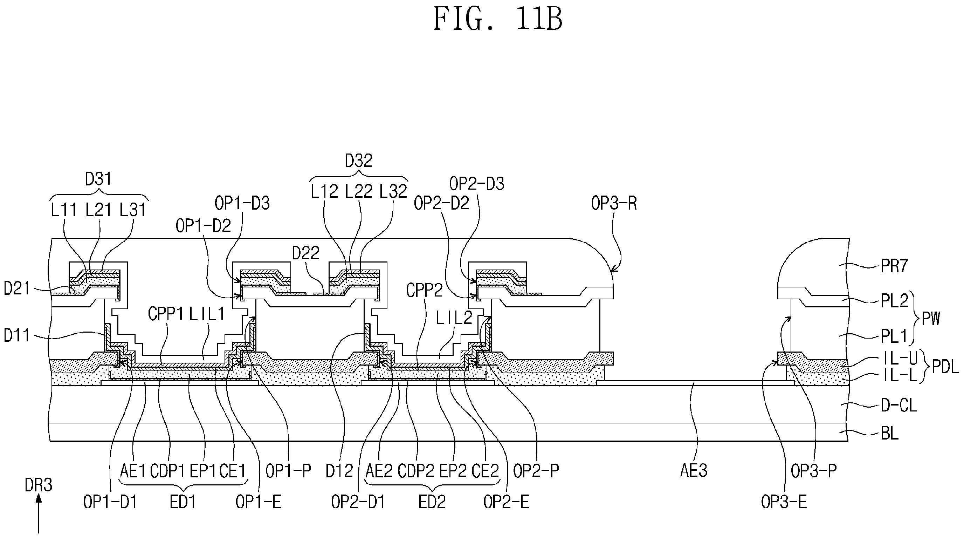

Referring to FIG. 11B, the fourth group of processes according to an embodiment may further include a process of forming a third partition wall opening OP3-P in the partition wall PW and a process of forming a third light emitting opening OP3-E in the pixel defining layer PDL.

The process of forming the third partition wall opening OP3-P in the partition wall PW may be performed through a first etching process and a second etching process. The descriptions of the first and second etching processes in the second group of processes described above with reference to FIGS. 9B and 9C may be similarly applied to the first and second etching processes in the fourth group of processes.

The first etching process in the fourth group of processes may be performed through a dry etching process of the first and second partition wall layers PL1 and PL2 by using the seventh photoresist layer PR7 as a mask.

The second etching process in the fourth group of processes may be performed through a wet etching process of the first and second partition wall layers PL1 and PL2 by using the seventh photoresist layer PR7 as a mask. The partition wall PW that defines the third partition wall opening OP3-P may have an undercut shape on the section.

The process of forming the third light emitting opening OP3-E in the pixel defining layer PDL may be performed through a third etching process. The description of the third etching process in the second group of processes described above with reference to FIG. 9D may be similarly applied to the third etching process in the fourth group of processes.

The third etching process in the fourth group of processes may be performed through a dry etching process of the lower insulating layer IL-L and the upper insulating layer IL-U by using the seventh photoresist layer PR7 as a mask. The pixel defining layer PDL that defines the third light emitting opening OP3-E may have an undercut shape on the section.

At least a portion of the third anode AE3 may be exposed by the third partition wall opening OP3-P and the third light emitting opening OP3-E, and a region of the third anode AE3 exposed by the first upper region UA1 (refer to FIG. 9D) of the third light emitting opening OP3-E may be defined as a third emissive region PXA-B (refer to FIG. 6).

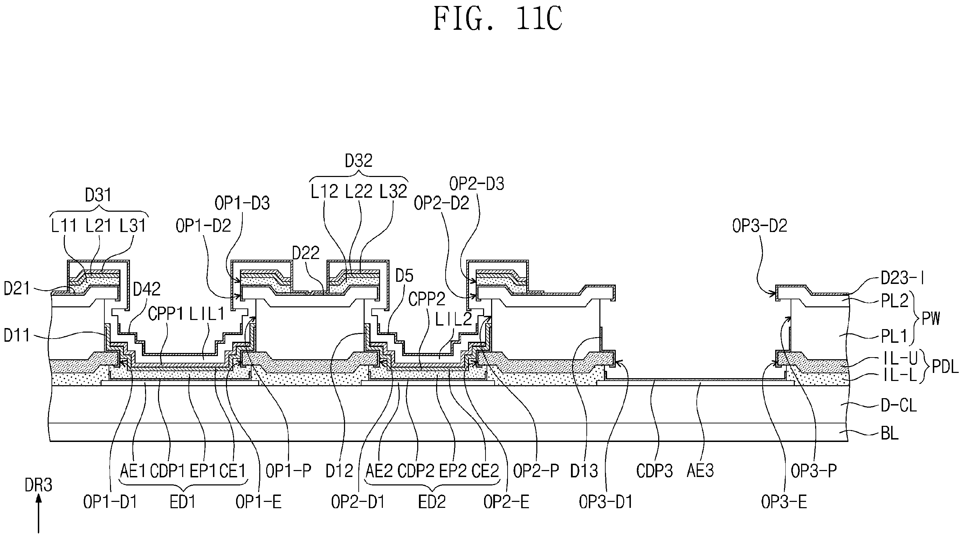

Referring to FIGS. 11B and 11C, the fourth group of processes according to an embodiment may further include a process of removing the seventh photoresist layer PR7.

Referring to FIG. 11C, the fourth group of processes according to an embodiment may further include a process of forming a third conductive pattern CDP3.

The process of forming the third conductive pattern CDP3 may be performed in a manner similar to the process of forming the first conductive pattern CDP1 in the second group of processes described above with reference to FIG. 9E. The third conductive pattern CDP3 may be formed through a deposition process of the third conductive material. In an embodiment, for example, the process of forming the third conductive pattern CDP3 may be performed through a sputtering process.

In the process of forming the third conductive pattern CDP3, a dummy pattern 1-3 D13 spaced apart from the third conductive pattern CDP3, a preliminary dummy pattern 2-3 D23-I, a dummy pattern 4-2 D42, and a fifth dummy pattern D5 may be formed together.

The dummy pattern 1-3 D13 may be disposed in the third light emitting opening OP3-E and the third partition wall opening OP3-P. A dummy opening 1-3 OP3-D1 may be defined in the dummy pattern 1-3 D13.

One portion of the preliminary dummy pattern 2-3 D23-I may be disposed on the second partition wall layer PL2 and the first and second lower inorganic encapsulation patterns LIL1 and LIL2, and another portion of the preliminary dummy pattern 2-3 D23-I may be disposed in the third partition wall opening OP3-P. A dummy opening 2-3 OP3-D2 may be defined in the preliminary dummy pattern 2-3 D23-I.

The dummy pattern 4-2 D42 may be separated from the preliminary dummy pattern 2-3 D23-I and may be disposed on the first lower inorganic encapsulation pattern LIL1 in the first partition wall opening OP1-P, and the fifth dummy pattern D5 may be separated from the preliminary dummy pattern 2-3 D23-I and may be disposed on the second lower inorganic encapsulation pattern LIL2 in the second partition wall opening OP2-P. In an embodiment of the disclosure, the separate dummy pattern 4-2 D42 and the fifth dummy pattern D5 may not be formed, and the preliminary dummy pattern 2-3 D23-I may be disposed in the first partition wall opening OP1-P while entirely covering the first lower inorganic encapsulation pattern LIL1 and may be disposed in the second partition wall opening OP2-P while entirely covering the second lower inorganic encapsulation pattern LIL2.

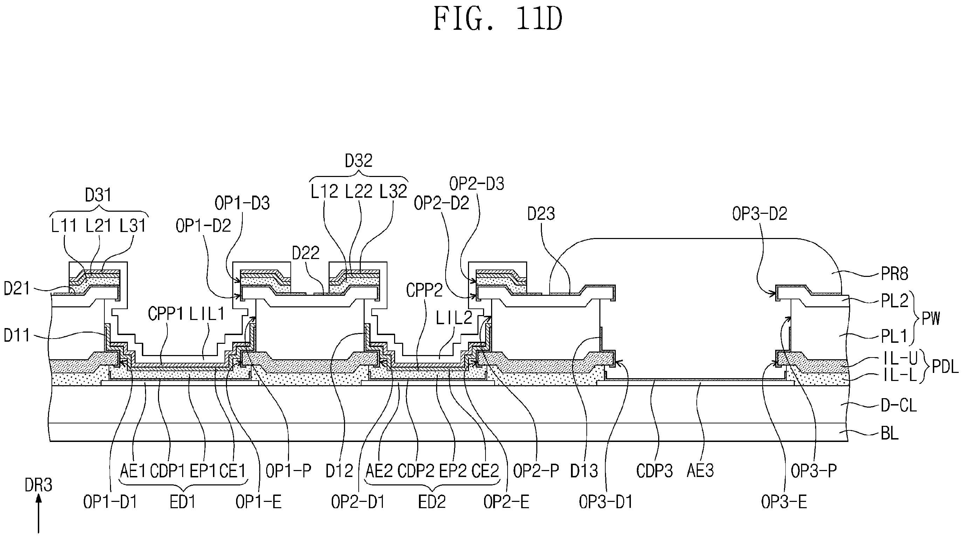

Referring to FIGS. 11C and 11D, the fourth group of processes according to an embodiment may further include a process of forming an eighth photoresist layer PR8 on the preliminary dummy pattern 2-3 D23-I. The eighth photoresist layer PR8 may be formed in a pattern form overlapping the third anode AE3 and the third light emitting opening OP3-E and may be formed not to overlap the first and second anodes AE1 and AE2.

The fourth group of processes according to an embodiment may further include a process of making the preliminary dummy pattern 2-3 D23-I subject to patterning to form a dummy pattern 2-3 D23. The process of making the preliminary dummy pattern 2-3 D23-I subject to patterning may be performed through a fourth etching process. The description of the fourth etching process in the second group of processes described above with reference to FIG. 9F may be similarly applied to the fourth etching process in the fourth group of processes.

The fourth etching process in the fourth group of processes may remove portions of the preliminary dummy pattern 2-3 D23-I overlapping the first and second anodes AE1 and AE2 by using the eighth photoresist layer PR8 as a mask. Accordingly, the dummy pattern 2-3 D23 with the dummy opening 2-3 OP3-D2 defined therein may be formed. In this process, the dummy pattern 4-2 D42 and the fifth dummy pattern D5 may be removed together.

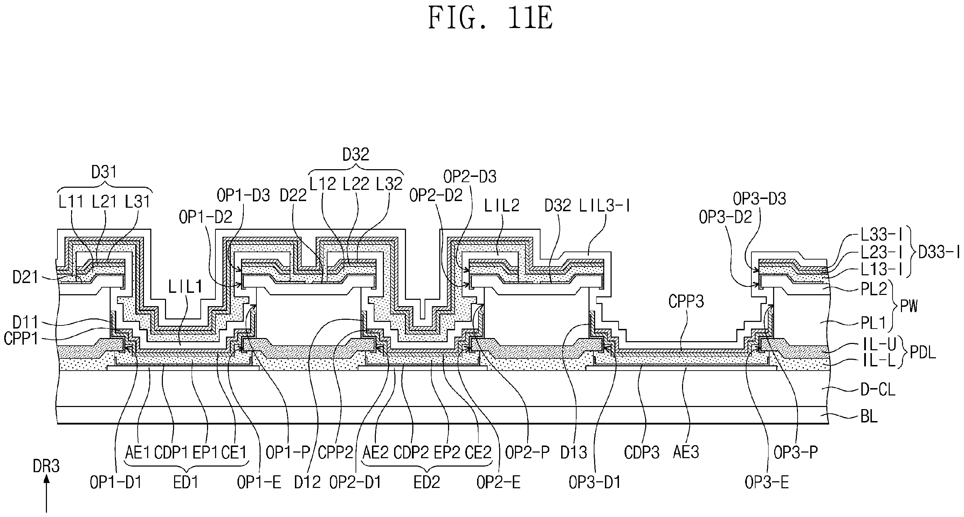

Referring to FIGS. 11D and 11E, the fourth group of processes according to an embodiment may further include a process of removing the eighth photoresist layer PR8.

Referring to FIG. 11E, the fourth group of processes according to this embodiment may include a process of forming a third emission pattern EP3, a process of forming a third cathode CE3, a process of forming a third capping pattern CPP3, and a process of forming a third preliminary lower inorganic encapsulation pattern LIL3-I. Alternatively, the process of forming the third capping pattern CPP3 may be omitted.

The process of forming the third emission pattern EP3 may be performed in a manner similar to the process of forming the first emission pattern EP1 in the second group of processes described above with reference to FIG. 9G. In an embodiment, for example, the third emission pattern EP3 may be formed by depositing a third organic material, and the third organic material may include a material different from the first organic material and the second organic material, or may include a material the same as the first organic material or the second organic material. In the process of forming the third emission pattern EP3, a preliminary dummy layer 1-3 L13-I spaced apart from the third emission pattern EP3 may be formed together.

The process of forming the third cathode CE3 may be performed in a manner similar to the process of forming the first cathode CE1 in the second group of processes described above with reference to FIG. 9G, and a preliminary dummy layer 2-3 L23-I spaced apart from the third cathode CE3 may be formed together.

The third anode AE3, the third conductive pattern CDP3, the third emission pattern EP3, and the third cathode CE3 may constitute the third light emitting element ED3.

The process of forming the third capping pattern CPP3 may be performed in a manner similar to the process of forming the first capping pattern CPP1 in the second group of processes described above with reference to FIG. 9G, and a preliminary dummy layer 3-3 L33-I spaced apart from the third capping pattern CPP3 may be formed together.

The preliminary dummy layers 1-3 L13-I, 2-3 L23-I, and 3-3 L33-I may constitute a preliminary dummy pattern 3-3 D33-I. One portion of the preliminary dummy pattern 3-3 D33-I may be disposed on the partition wall PW, another portion of the preliminary dummy pattern 3-3 D33-I may be disposed in the first partition wall opening OP1-P and may cover the first lower inorganic encapsulation pattern LIL1, and another portion of the preliminary dummy pattern 3-3 D33-I may be disposed in the second partition wall opening OP2-P and may cover the second lower inorganic encapsulation pattern LIL2. A dummy opening 3-3 OP3-D3 may be defined in the preliminary dummy pattern 3-3 D33-I.

The third preliminary lower inorganic encapsulation pattern LIL3-I may be formed in a manner similar to the process of forming the first preliminary lower inorganic encapsulation pattern LIL1-I in the second group of processes described above with reference to FIG. 9G. One portion of the third preliminary lower inorganic encapsulation pattern LIL3-I may cover the third cathode CE3 in the third partition wall opening OP3-P, and another portion of the third preliminary lower inorganic encapsulation pattern LIL3-I may cover the preliminary dummy pattern 3-3 D33-I.

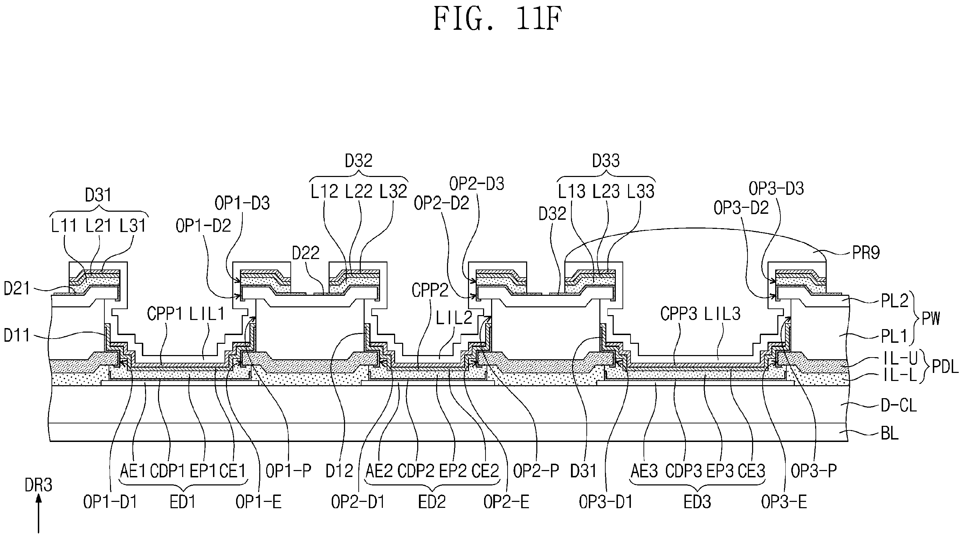

Referring to FIGS. 11E and 11F, the fourth group of processes according to this embodiment may include a process of forming a ninth photoresist layer PR9 on the third preliminary lower inorganic encapsulation pattern LIL3-I. The ninth photoresist layer PR9 may be formed in a pattern form overlapping the third anode AE3 and the third light emitting opening OP3-E and may be formed not to overlap the first and second anodes AE1 and AE2.

The fourth group of processes according to an embodiment may further include a process of making the third preliminary lower inorganic encapsulation pattern LIL3-I subject to patterning to form the third lower inorganic encapsulation pattern LIL3 and a process of making the preliminary dummy pattern 3-3 D33-I subject to patterning to form a dummy pattern 3-3 D33.

The process of making the third preliminary lower inorganic encapsulation pattern LIL3-I subject to patterning may be performed through a fifth etching process. The description of the fifth etching process in the second group of processes described above with reference to FIG. 9H may be similarly applied to the fifth etching process in the fourth group of processes.

The fifth etching process in the fourth group of processes may remove portions of the third preliminary lower inorganic encapsulation pattern LIL3-I overlapping the first and second anodes AE1 and AE2 by using the ninth photoresist layer PR9 as a mask. Accordingly, the third lower inorganic encapsulation pattern LIL3 may be formed.

The process of making the preliminary dummy pattern 3-3 D33-I subject to patterning may be performed through a sixth etching process. The description of the sixth etching process in the second group of processes described above with reference to FIG. 9H may be similarly applied to the sixth etching process in the fourth group of processes.

The sixth etching process in the fourth group of processes may remove portions of the preliminary dummy pattern 3-3 D33-I overlapping the first and second anodes AE1 and AE2 by using the ninth photoresist layer PR9 as a mask. Accordingly, the dummy pattern 3-3 D33 with the dummy opening 3-3 OP3-D3 defined therein may be formed. In an embodiment, dummy layers 1-3 L13, 2-3 L23, and 3-3 L33 may be formed by removing portions of the preliminary dummy layers 1-3 L13-I, 2-3 L23-I, and 3-3 L33-I that overlap the first and second anodes AE1 and AE2, and the dummy layers 1-3 L13, 2-3 L23, and 3-3 L33 may constitute the dummy pattern 3-3 D33.

Referring to FIGS. 11F and 11G, the fourth group of processes according to an embodiment may further include a process of removing the ninth photoresist layer PR9.

The fifth group of processes may be performed after the fourth group of processes. In an embodiment, the display panel DP (refer to FIG. 12) including the encapsulation layer TFE (refer to FIG. 12) may be completed through the fifth group of processes.

Referring to FIG. 12, the fifth group of processes according to an embodiment may further include a process of forming an organic encapsulation layer OL on the partition wall PW and the first to third lower inorganic encapsulation patterns LIL1, LIL2, and LIL3 and a process of forming an upper inorganic encapsulation layer UIL on the organic encapsulation layer OL. Accordingly, the display panel DP including the base layer BL, the circuit element layer D-CL, the display element layer D-OL, and the encapsulation layer TFE may be formed.

According to embodiments of the disclosure, the emission patterns may be subjected to patterning without using a metal mask. Accordingly, the display panel may have improved process reliability and may easily implement high resolution.

According to embodiments of the disclosure, a void may be effectively prevented from being formed between the anodes and the emission patterns since a separate etch stopper is not provided between the anodes and the pixel defining layer. Accordingly, the display panel may effectively prevent poor light emission and poor visibility.

According to embodiments of the disclosure, deterioration in a hole injection function may be prevented by providing the conductive patterns covering the anodes even though a separate etch stopper is not disposed and therefore the anodes are damaged during a patterning process of the pixel defining layer. Accordingly, an increase in the drive voltage of the light emitting elements may be prevented, and the display panel may have improved display efficiency.

According to embodiments of the disclosure, the conductive patterns formed to cover the anodes exposed by the light emitting openings of the pixel defining layer may be prevented from being electrically connected with the partition wall disposed on the pixel defining layer since the pixel defining layer has the under-cut shape. Accordingly, lateral leakage current may be prevented from being generated between the anodes and the partition wall, and thus the display panel may have improved electrical reliability.

According to embodiments of the disclosure, light emitting elements having high resolution and improved process reliability may be formed by the display panel manufacturing method. In such embodiments, the display panel manufacturing method may improve display efficiency and electrical reliability while preventing poor light emission and poor visibility.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the spirit or scope of the invention as defined by the following claims.

## Claims

1. A display panel comprising:
a base layer;
a first anode disposed on the base layer;
a pixel defining layer disposed on the base layer, wherein the pixel defining layer is provided with a first light emitting opening which exposes at least a portion of the first anode;
a partition wall disposed on the pixel defining layer, wherein the partition wall is provided with a first partition wall opening corresponding to the first light emitting opening;
a first conductive pattern disposed in the first light emitting opening and disposed on the first anode;
a first cathode at least partially disposed in the first partition wall opening and disposed over the first conductive pattern; and
a first emission pattern disposed between the first conductive pattern and the first cathode,
wherein the first conductive pattern contacts a side surface of the pixel defining layer which defines the first light emitting opening.

2. The display panel of claim 1, wherein the pixel defining layer includes:
a lower insulating layer including a first insulating material; and
an upper insulating layer including a second insulating material different from the first insulating material, wherein the upper insulating layer is disposed on the lower insulating layer.

3. The display panel of claim 2, wherein the lower insulating layer includes a lower inner surface which defines a first lower region of the first light emitting opening,
wherein the upper insulating layer includes an upper inner surface which defines a first upper region of the first light emitting opening, and
wherein the lower inner surface is disposed to be recessed in a direction away from a center of the first anode with respect to the upper inner surface;
and/or wherein the lower insulating layer contacts an upper surface of the first anode, and
wherein the first conductive pattern contacts the lower inner surface.

4. The display panel of claim 2 or 3, wherein the partition wall includes:
a first partition wall layer disposed on the upper insulating layer, wherein the first partition wall layer includes a first partition wall inner surface which defines a second lower region of the first partition wall opening; and
a second partition wall layer disposed on the first partition wall layer, wherein the second partition wall layer includes a second partition wall inner surface which defines a second upper region of the first partition wall opening, and
wherein the first partition wall inner surface is disposed to be recessed in the direction away from the center of the first anode with respect to the upper inner surface and the second partition wall inner surface.

5. The display panel of any preceding claim, further comprising:
a first first dummy pattern spaced apart from the first conductive pattern and disposed in the first light emitting opening and the first partition wall opening, wherein the first first dummy pattern includes a same material as the first conductive pattern.

6. The display panel of claim 5, wherein the first first dummy pattern contacts the upper inner surface and the first partition wall inner surface, and
wherein a first dummy opening, which is disposed in the first light emitting opening and the first partition wall opening, is defined in the first first dummy pattern;
and/or wherein the first first dummy pattern further contacts a lower surface of the upper insulating layer exposed by the lower insulating layer.

7. The display panel of claim 5 or 6, further comprising:
a first second dummy pattern spaced apart from the first conductive pattern and the first first dummy pattern, wherein the first second dummy pattern includes a same material as the first conductive pattern, a portion of the first second dummy pattern is disposed on the partition wall, and a remaining portion of the first second dummy pattern is disposed in the first partition wall opening,
wherein the first second dummy pattern makes contact with the second partition wall inner surface, and
wherein a second dummy opening, which is disposed in the first partition wall opening, is defined in the first second dummy pattern.

8. The display panel of claim 7, wherein the first second dummy pattern further contacts a lower surface of the second partition wall layer exposed by the first partition wall layer.

9. The display panel of claim 7 or 8, further comprising:
a third dummy pattern including a first dummy layer and a second dummy layer, wherein the first dummy layer is spaced apart from the first emission pattern and disposed on the first second dummy pattern and includes a same material as the first emission pattern, and the second dummy layer is spaced apart from the first cathode and disposed on the first dummy layer and includes a same material as the first cathode,
wherein a third dummy opening corresponding to the first light emitting opening is defined in the third dummy pattern.

10. The display panel of any preceding claim, further comprising:
a second anode disposed on the base layer and spaced apart from the first anode;
a second conductive pattern disposed on the second anode;
a second emission pattern disposed on the second conductive pattern; and
a second cathode disposed on the second emission pattern,
wherein a second light emitting opening is defined in the pixel defining layer to expose at least a portion of the second anode,
wherein a second partition wall opening corresponding to the second light emitting opening is defined in the partition wall, and
wherein the second conductive pattern, the second emission pattern, and the second cathode are disposed in the second light emitting opening and the second partition wall opening.

11. The display panel of claim 10, when also dependent on any one of claims 7 to 9, further comprising:
a second first dummy pattern spaced apart from the second conductive pattern and disposed in the second light emitting opening and the second partition wall opening, wherein the second first dummy pattern including a same material as the second conductive pattern; and
a second second dummy pattern spaced apart from the second conductive pattern, the second first dummy pattern, and the first second dummy pattern, wherein the second second dummy pattern includes a same material as the second conductive pattern, a portion of the second second dummy pattern is disposed on the partition wall, and a remaining portion of the second second dummy pattern is disposed in the second partition wall opening.

12. The display panel of any one of claims 5 to 7, wherein the first cathode contacts the first first dummy pattern in the first partition wall opening.

13. The display panel of claim 4, wherein the first cathode contacts the first partition wall inner surface in the first partition wall opening.

14. The display panel of claim 3, wherein the pixel defining layer further includes:
a first additional insulating layer disposed between the base layer and the lower insulating layer, wherein the first additional insulating layer includes a first additional inner surface which defines a first additional region of the first light emitting opening; and
a second additional insulating layer disposed between the first additional insulating layer and the lower insulating layer, wherein the second additional insulating layer includes a second additional inner surface which defines a second additional region of the first light emitting opening,
wherein the first additional inner surface is disposed to be recessed in the direction away from the center of the first anode with respect to the upper inner surface and the second additional inner surface,
wherein a portion of an upper surface of the first anode contacts the first additional insulating layer, and
wherein the first conductive pattern contacts the first additional inner surface.

15. The display panel of claim 14, wherein the first additional insulating layer includes the first insulating material, and
wherein the second additional insulating layer includes the second insulating material;
and/or wherein the display panel further comprises:
an additional dummy pattern spaced apart from the first conductive pattern and in contact with the second additional insulating layer and the lower insulating layer, wherein the additional dummy pattern includes a same material as the first conductive pattern.

16. The display panel of claim 2, wherein the first insulating material includes silicon nitride (SiNₓ), and
wherein the second insulating material includes silicon oxide (SiOₓ);
and/or wherein each of the lower insulating layer and the upper insulating layer has a thickness in a range of about 1000 Å to about 2000 Å.

17. The display panel of any preceding claim, wherein the first conductive pattern includes a same material as a material included in the first anode;
and/or wherein the first conductive pattern includes transparent conductive oxide;
and/or wherein the first conductive pattern has a thickness in a range of about 30Å to about 70Å.

18. A display panel comprising:
a base layer;
an anode disposed on the base layer;
a lower insulating layer disposed on the base layer, wherein the lower insulating layer is provided with a lower opening defined therein to expose a portion of the anode;
an upper insulating layer disposed on the lower insulating layer, wherein the upper insulating layer is provided with an upper opening defined therein to correspond to the lower opening;
a partition wall disposed on the upper insulating layer, wherein the partition wall is provided with a partition wall opening defined therein to correspond to the upper opening;
a conductive pattern disposed in the lower opening and disposed on the anode;
a cathode at least partially disposed in the partition wall opening and disposed over the conductive pattern; and
an emission pattern disposed between the conductive pattern and the cathode,
wherein on a section, the upper opening has a smaller width in one direction than the lower opening.

19. The display panel of claim 18, wherein the partition wall includes:
a first partition wall layer disposed on the upper insulating layer, wherein the first partition wall layer includes a first partition wall inner surface which defines one region of the partition wall opening; and
a second partition wall layer disposed on the first partition wall layer, wherein the second partition wall layer includes a second partition wall inner surface which defines a remaining region of the partition wall opening, and
wherein on the section, the remaining region of the partition wall opening has a smaller width in the one direction than the one region of the partition wall opening.

20. A method for manufacturing a display panel, the method comprising:
providing a preliminary display panel including a base layer and a first anode disposed on the base layer;
forming, on the base layer, a preliminary pixel defining layer including a lower insulating layer including a first insulating material and an upper insulating layer including a second insulating material different from the first insulating layer;
forming a preliminary partition wall on the preliminary pixel defining layer;
patterning the preliminary partition wall to form a partition wall with a first partition wall opening defined therein;
patterning the preliminary pixel defining layer to form a pixel defining layer with a first light emitting opening defined therein to expose at least a portion of the first anode;
forming a first conductive pattern to cover the first anode exposed by the first light emitting opening;
forming a first emission pattern on the first conductive pattern; and
forming a first cathode on the first emission pattern, wherein the first cathode is at least partially disposed in the first partition wall opening.

21. The method of claim 20, wherein the patterning the preliminary partition wall includes:
performing a first etching process by etching a first partition wall layer and a second partition wall layer of the preliminary partition wall to form a first preliminary partition wall opening in the preliminary partition wall; and
performing a second etching process by etching the first partition wall layer and the second partition wall layer to form the first partition wall opening from the first preliminary partition wall opening, and
wherein in the preforming the second etching process, an etch rate of the first partition wall layer is higher than an etch rate of the second partition wall layer.

22. The method of claim 20 or 21, wherein the patterning the preliminary pixel defining layer includes performing a third etching process, and
wherein in the performing the third etching process, an etch rate of the lower insulating layer is higher than an etch rate of the upper insulating layer;
and/or wherein the third etching process is performed through a dry etching.

23. The method of any one of claims 20 to 22, wherein in the forming of the first conductive pattern, a first dummy pattern and a second preliminary dummy pattern are additionally formed, wherein the first dummy pattern is spaced apart from the first conductive pattern and disposed in the first light emitting opening and the first partition wall opening, and the second preliminary dummy pattern is spaced apart from the first conductive pattern and the first dummy pattern and includes one portion disposed on the partition wall and a remaining portion disposed in the first partition wall opening.

24. The method of claim 23, further comprising:
patterning the second preliminary dummy pattern to form a second dummy pattern after the forming of the first conductive pattern and before the forming of the first emission pattern,
wherein in the providing the preliminary display panel, the preliminary display panel further includes a second anode spaced apart from the first anode and disposed on the base layer, and
wherein the patterning the second preliminary dummy pattern includes removing a portion of the second preliminary dummy pattern overlapping the second anode.

25. The method of claim 24, further comprising:
forming, in the partition wall, a second partition wall opening to overlap the second anode after the forming of the first cathode;
forming, in the pixel defining layer, a second light emitting opening to expose at least a portion of the second anode;
forming a second conductive pattern to cover the second anode exposed by the second light emitting opening;
forming a second emission pattern on the second conductive pattern; and
forming, on the second emission pattern, a second cathode at least partially disposed in the second partition wall opening.
